# EUROPEAN PATENT SPECIFICATION

(11) **EP 0 283 519 B1**
(45) Date of publication and mention of the grant of the patent: **13.04.1994**
(21) Application number: 87906208.1
(22) Date of filing: 24.09.1987
(51) Int. Cl.: H01J 27/18, H01J 37/32

(54) **ION GENERATION APPARATUS, THIN FILM FORMATION APPARATUS USING THE ION GENERATION APPARATUS, AND ION SOURCE**
IONENERZEUGENDE APPARATUR, DÜNNSCHICHTBILDENDE VORRICHTUNG UNTER VERWENDUNG DER IONENERZEUGENDEN APPARATUR UND IONENQUELLE
GENERATEUR IONIQUE, INSTALLATION DE FORMATION DE FILMS MINCES UTILISANT CE GENERATEUR ET SOURCE D'IONS

(30) Priority: 29.09.1986 JP 230829/86; 29.09.1986 JP 230830/86; 21.08.1987 JP 208003/87; 21.08.1987 JP 208004/87; 28.08.1987 JP 214899/87; 28.08.1987 JP 214900/87
(43) Date of publication of application: 28.09.1988
(73) Proprietor: NIPPON TELEGRAPH AND TELEPHONE CORPORATION, Tokyo (JP)
(72) Inventor: MATSUOKA, Morito, Hitachi-shi Ibaraki 319-12 (JP); ONO, Ken'ichi, Mito-shi Ibaraki 311-41 (JP)
(74) Representative: Beresford, Keith Denis Lewis
(86) International application number: PCT/JP87/00695
(87) International publication number: WO 88/02546

(56) References cited:
- EP-A- 0 173 164
- EP-A- 0 238 397
- GB-A- 1 399 603
- JP-A- 5 254 898
- NUCLEAR INSTRUMENTS & METHODS IN PHYSICS RESEARCH, vol. 213, no. 2/3, August 1983, pages 165-169, North-Holland Publisching Co., Amsterdam, NL; M. DELAUNAY et al.: "Essais de production d'ions métalliques dans la source d'ions multicharges MINIMAFIOS"
- NUCLEAR INSTRUMENTS & METHODS IN PHYSICS RESEARCH, SECTION A, vol. 227, no. 1, November 1984, pages 6-10, North-Holland Publishing, Co., Amsterdam, NL; A. CHETIOUI et al.: "MINIMAFIOS, source d'ions multicharges fournissant des faisceaux d'ions d'aluminium complètement épluchés"
- JAPANESE JOURNAL OF APPLIED PHYSICS, PART. 2. LETTERS, vol. 26, no. 2, February 1987, pages L100-L102, Tokyo, JP; Y. YOSHIDA et al.: "PIG-type compact microwave metal ion source"

## Description

The present invention relates to an ionization apparatus capable of efficient ionization by utilizing a sputtering process carried out by high density plasma, a thin film forming apparatus capable of forming various thin films at a high rate and a high degree of efficiency with ions and neutral particles produced by the ionization apparatus and an ion source with a high degree of efficiency and a high degree of yield (high ion current) from which the ions produced by the ionization apparatus are extracted so as to form various thin films and to carry out an etching process.

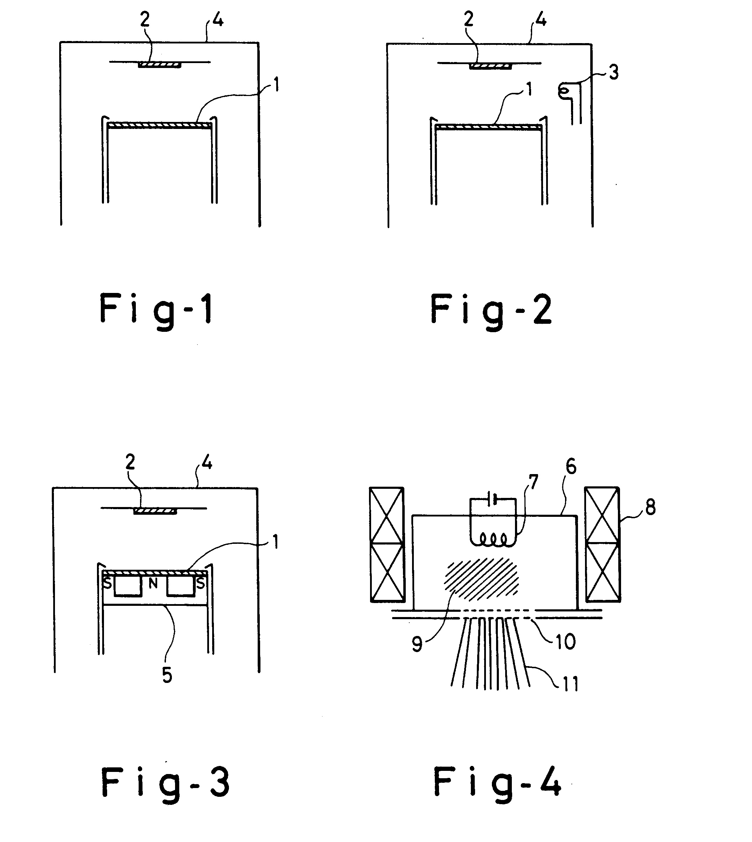

The so-called sputtering apparatus for sputtering a target as a thin film formation element in plasma, thereby forming thin films, has been widely used to form films of various materials in various fields. For instance, as shown in Fig. 1, a conventional sputtering apparatus in which a target 1 and a substrate 2 are disposed in opposing relationship with each other in a vacuum chamber 4 which is generally called two-electrode sputtering apparatus (Refer to F.M.D'HEURLE: Metall. Trans. Vol. 1, March, 1970, 725-732), or the three-electrode sputtering apparatus in which, as shown in Fig. 2 a third electrode 3 for emitting electrons is additionally disposed (W.W.Y. Lee and D.Oblas: J. Appl. Phys. Vol. 46, No. 4, 1975, 1728-1732) and furthermore the magnetron sputtering process (Refer to R.K. Waits: J. Vac. Sci. Technol, Vol. 15, No. 2, 1978, pp. 179-187) in which, as shown in Fig. 3, a magnet 5 is used to apply a magnetic field of suitable strength to the target 1 so that high density and low temperature plasma is produced, whereby a thin film is formed at a high rate, have been used and are well known to those skilled in the art. These apparatus mainly comprise the vacuum chamber 4 with the target 1 as a thin film forming element and the substrate 2 upon which a thin film is formed, a gas introduction system and a gas discharge system and plasma is generated within the vacuum chamber 4.

In order to form a thin film at a high rate by one of the above-mentioned apparatus, it becomes necessary to maintain plasma at a high density. However, in the case of the two-electrode or diode sputtering apparatus, the higher the density of plasma, the more quickly a voltage applied to the target is increased. At the same time, the temperature of the substrate quickly rises because of the bombardment on the substrate of high-energy particles and high-energy electrons within the plasma, and also the damage of formed film increases. Therefore, this apparatus can be only used for special heat-resisting substrates, thin film materials and film compositions. In the case of the three-electrode or triode sputtering apparatus, the plasma density is increased because the electrons are supplied from the third electrode into the plasma, but just like the two-electrode or diode sputtering apparatus, if it is desired to form a thin film at a high rate, the temperature of the substrate quickly rises. As a result, only a limited small number of thin film materials and substrates may be used.

On the other hand, in the case of the high rate magnetron sputtering apparatus, the gamma (y) electrons (secondary electrons) emitted from the target which are needed to ionize the gas in the plasma are confined over the surface of the target by both magnetic and electric field, so that dense plasma can be produced at a low gas pressure. In practice, the high rate sputtering processes are carried out at a low gas pressure of the order of 0,1 Pa (10-³ Torr), so that they are widely used for the formation of various thin films at a high rate. However, in the case of the sputtering apparatus just- described above, because of the bombardment of the ions in the plasma (mainly Ar⁺ ions), the high-energy neutral particles emitted from the target (mainly Ar reflected at the surface of the target) and the negative ions on the film being formed, the change in composition of the thin film occur and the film or the substrate is damaged. In practice, it is well known to those skilled in the art that in the case of the formation of a ZnO film, the composition of the portion of the ZnO film immediately above the erosion area of the target and that of the other portion of the ZnO film are completely different from each other. Therefore, the bombardment of the high-energy particles on the substrate presents serious problems. In addition, the erosion areas of the target are distributed locally, so that this apparatus has a lower degree of utilization efficiency and a defect that it cannot be used at an industrial scale.

Furthermore, in the case of the formation of thin films by the prior art sputtering apparatus, gases and particles in the plasma are not ionized satisfactorily and particles which are sputtered as thin film formation elements land on the substrate as almost numeral state. Therefore, since a sufficient degree of activity of reaction cannot be attained, in order to obtain some oxides and thermally nonequilibrium materials, a temperature of the substrate must be raised to a high temperature ranging from 500 _{°} C to 800 _{°} C. Moreover, almost all the power supplied to the plasma is consumed in the form of the thermal energy, so that the ratio of the power used for the formation of plasma (for electrolytic dissociation) to the power supplied to the apparatus is low and consequently the power efficiency drops.

Furthermore, in any of the above-mentioned sputtering apparatus, the stable discharge cannot be ensured at a gas pressure lower than 0.1 Pa (10-³ Torr), so that there is a defect that many impurities are entrapped in the thin film.

Meanwhile, Matsuo et al. have proposed a process for forming a thin film in which plasma including a material to be deposited is generated under the electron cyclotron resonance (ECR) condition by using a microwave and the plasma is drawn on a specimen for forming the thin film (U.S. Patent No. 4,401,054). However, this process cannot form thin metal films and thin metal compound films. Matsuo and Ono (U.S. Patent No. 4,492,620) and Ono et al. (Jpn. J. Appl. Phys. Vol. 23, NO. 8, 1984, L534-L536) have disclosed a microwave plasma deposition apparatus in which a target is sputtered by microwave plasma utilizing ECR and sputtered particles are made to deposit on the surface of the substrate, thereby forming a thin film.

These apparatus accomplish sputtering by utilizing the excellent features of the microwave plasma such as the capability of discharging at 0,001 Pa - 0.01 Pa (10-^{5 -} 10-⁴ Torr) and of producing highly active plasma. Therefore, these processes are excellent processes for accomplishing highly active sputtering at low gas pressures.

However, the sputtering rate is not so high and the ionization ratio of the particles sputtered from the target is low and further the energy control cannot be accomplished in a satisfactory manner because the target is located outside of the plasma generating chamber.

Japanese Patent Application Laid-Open Nos. 61-87869 and 61-194174 disclose apparatus in which microwave plasma generated under ECR condition is confined by a mirror magnetic field so that sputtering can be accomplished by high density plasma, In these apparatus, it is possible to sputter in a high vacuum of from 0,01 to 0,001 Pa (10-⁴ to 10-⁵ Torr). However, in the case of the former (No. 61-87869), since both the target and the substrate are disposed in high density plasma, there arises the problem that high-energy neutral particles and charged particles directly damage the surface of the substrate, resulting in the degradation of the formed thin film. It has a further problem that a mechanism for cooling the surface of the substrate becomes complicated bacause the temperature rises due to the high density plasma. In the case of the latter (No. 61-194174), the sputtering process is carried out by drawing plasma, which is generated in a mirror magnetic field, by another magnetic apparatus to the surface of the target. In this case, the target is located outside of the plasma generating chamber for generating high density plasma, so that the ionization ratio of the particles sputtered from the target is low and consequently this apparatus is not adapted to form a thin film by highly reactive ions.

In the case of the formation of thin films by sputtering, the following conditions must be satisfied:
(1) There is no rapid temperature rise causing the damages to the substrate and the film and the formation of a thin film can be carried out at a high rate (that is, high density plasma is required).
(2) The energy of particles can be controlled over a wide range.
(3) The dispersion of energy of the particles must be reduced to minimum as practically as possible.
(4) The ionization ratio of the plasma must be high and the plasma must be active.
(5) Plasma can be generated under a low gas pressure.

So far a thin film formation apparatus which can satisfy all of the conditions described above has not been realized.

Meanwhile, the ionization apparatus is used as an ion source. Various ion sources utilizing the plasma have been widely used as the so-called ion beam sputtering apparatus in which the ions are used to sputter the target, thereby forming thin films and as an etching apparatus used in the fabrication of integrated circuits. The ionization apparatus has many types such as the Kaufman type, the duoplasmatron type and so on. Of all the types, the Kaufman type has been widely used as an ion source. In the case of the Kaufman type ionization apparatus, as shown in Fig. 4, a filament 7 for emitting thermal electrons is mounted in a plasma generating chamber 6 and is used as a negative electrode; the discharge is caused in a magnetic field produced by an electromagnet 8, thereby generating plasma 9; and the ions in the plasma are used to produce an ion beam 11 through a plurality of extraction grids 10 (Refer to H.R. Kaufman et al.: J. Vac. Sci. Technol., Vol. 21, No. 3, 1982, pp. 725-736). In the Kaufman type ion source, kinds of ions, that is, the kinds of gases to be introduced into the plasma generating chamber 6 are limited to inert gases such as Ar, because the filament 7 for emitting thermal electrons is used as an ion source. That is, if a reactive gas is used, it reacts with the filament 7, so that the stable plasma generation and the stable ion extraction cannot be made. The apparatus has the further problems that the characteristics drop due to the ageing of the filament 7, the cumbersome maintenance of the source such as the replacement of the filament 7 and the impairment of the reproducibility due to the variations in distribution of ion extraction which are caused by the variations in installation of the filament 7. In addition, the filament for emitting the thermal electrons is always exposed to the plasma 9 and the high-energy ions in the plasma impinge on the filament 7. As a consequence, in the extracted particles a material of the filament 7 such as tungsten is intermixed as an impurity. In the case of the above-mentioned ion source, the ions which can be extracted from the ion source are limited to the ions of inert gases as described above and it follows therefore that it is essentially impossible to obtain ions of metals such as aluminum (Al), copper (Cu), iron (Fe) and so on. Same is true for the duoplasmatron type ion source (Refer to M.E. Ab- delaziz and A.M. Ghander: IEEE Trans. Nucl. Sci., June 1967, pp. 46-52).

In case of using an ion source for forming films or etching, it is preferable that the current density of the extracted ion beam is as highly as possible. However, in the cases of the conventional ion sources using a filament, the amount of ions is dependent upon the amount of electrons emitted from the filament, for this reason it has been essentially impossible so far to make an ion source from which a large amount of ions can be extracted. Furthermore, in the cases of the conventional ion sources, the stable discharge cannot be maintained in the plasma generating chamber at a low gas pressure lower than 0,1 Pa (10-³ Torr). Therefore, there arises the problem that the extracted ions contain a greater amount of impurities.

Meanwhile, there have been disclosed an apparatus (U.S. Patent No. 4,450,031) in which, in order to obtain a stable ion beam at a high current, ions are extracted through an electrode system consisting of a screening electrode and an ion extraction electrode from plasma generated by the electron cyclotron resonance (ECR) excited by a microwave or generated by other method, and an apparatus (Japanese Patent Application Laid-Open No. 60-264032) in which the ion extraction electrode for extracting the ions from plasma generated by the microwave ECR process is improved. In these ion sources, a high current ion beam can be derived from high density plasma in a stable manner, but the kinds of ions obtained are limited to plasma generation gases, so that it is impossible to obtain ions except gaseous ions. That is, it is impossible to obtain a beam of metal ions.

The conditions required as ion sources may be summarized as follows:
(1) A great amount or ions are extracted (high current ions).
(2) Impurities are excluded as much as possible.
(3) The energy of ions can be controlled over a wide range.
(4) Not only the ions of inert gases but also various ions such as metallic ions can be derived.

However, even a single ion source which can satisfy all of the above-described conditions has not been realized yet.

Ion generator apparatus is disclosed in Nuclear Instruments and Methods in Physics Research 213 (1983), pages 165 to 168. This document discloses in Fig. 1 an ion generator having a cavity resonator (C) into which microwaves are introduced in a direction perpendicular to the magnetic flux of a mirror magnetic field producing means (S₃, S₄), a target (M) being disposed in the resonator (C), an extraction mechanism (E₁, E₂) being arranged at an end portion of the resonator, and second magnetic field producing means (H) surrounding the resonator.

European Patent Application EP-A-173,164 also shows an apparatus of a similar kind but connected to a specimen chamber.

The present invention was made to overcome the above and other problems encountered in the conventional devices.

According to the present invention there is provided an apparatus comprising:
a vacuum chamber including a vacuum waveguide having a microwave introduction window at one end thereof, the microwave introduction window being connected to a microwave waveguide, a plasma generation chamber having a diameter and a length sufficient to define a microwave cavity resonator for causing the resonance of the introduced microwave and an end portion of the plasma generation chamber all connected with each other in the order named and further having a gas introduction inlet, further comprising
a target to be sputtered disposed in the plasma generation chamber and at least one pair of magnetic field producing means disposed around the vacuum waveguide and the end portion of the plasma generation chamber so that a mirror field is produced in such a way that the center of the magnetic field exists within the plasma generation chamber characterised in that the target is attached to a portion of the side surface of the plasma generation chamber and a power source is provided for applying a negative voltage to the target.

### BRIEF DESCRIPTION OF THE DRAWINGS

Fig. 1 is a schematic sectional view showing a conventional two electrode or diode sputtering apparatus;
Fig. 2 is a schematic sectional view showing a conventional three electrode or triode sputtering apparatus;
Fig. 3 is a schematic sectional view showing a conventional magnetron sputtering apparatus;
Fig. 4 is a schematic sectional view showing a conventional Kaufman type ion source;
Fig. 5 is a sectional view showing a first embodiment of a thin film forming apparatus in accordance with the present invention; Fig. 5A is a fragmentary view, on enlarged scale, thereof;
Fig. 6 is a partial cutaway view in perspective showing the first embodiment shown in Fig. 5;
Fig. 7 is a diagram illustrating a magnetic field, motion of ions and a potential distribution;
Figs. 8 and 9 are a sectional view and a partial cutaway view in perspective showing a first embodiment of an ion source in accordance with the present invention, respectively;
Fig. 10 is a sectional view showing a second embodiment of a thin film forming apparatus in accordance with the present invention;
Fig. 11 is a diagram illustrating a distribution of the intensity of a magnetic field in the direction of a magnetic flux in the second embodiment shown in Fig. 10;
Figs. 12 and 13 are diagrams illustrating the states of generated plasma with and without a yoke, respectively;
Fig. 14 is a sectional view showing a third embodiment of a thin film forming apparatus in accordance with the present invention;
Figs. 15 and 16 are diagrams illustrating a magnetic field intensity and a state of generated plasma, respectively, in the third embodiment shown in Fig. 14;
Fig. 17 is a partial cutaway view in perspective showing a fourth embodiment of a thin film forming apparatus in accordance with the present invention;
Figs. 18A and 18B are diagrams for explaining the motion of electrons on the surface of a target, respectively;
Fig. 19 is a diagram illustrating a magnetic field, motion of ions and a potential distribution in the fourth embodiment shown in Fig. 17;
Fig. 20 is a sectional view showing a fifth embodiment of a thin film forming apparatus in accordance with the present invention;
Fig. 21 is a diagram illustrating a magnetic field intensity distribution in the fifth embodiment shown in Fig. 20;
Fig. 22 is a partial cutaway view in perspective showing a sixth embodiment of a thin film forming apparatus in accordance with the present invention;
Fig. 23 is a sectional view showing a seventh embodiment of a thin film forming apparatus in accordance with the present invention;
Fig. 24 shows the distribution of the magnetic field intensity in the embodiment shown in Fig. 23;
Fig. 25 is a sectional view showing a second embodiment of an ion source in accordance with the present invention;
Figs. 26 and 27 are diagrams illustrating a distribution of the magnetic field intensity and a state of generated plasma, respectively, in the second embodiment shown in Fig. 25;
Fig. 28 is a sectional view showing a third embodiment of an ion source in accordance with the present invention;
Figs. 29 and 30 are diagrams illustrating a distribution of the intensity of a magnetic field and a state of the generated plasma in the embodiment shown in Fig. 28;
Fig. 31 is a partial cutaway view in perspective showing a fourth embodiment of an ion source in accordance with the present invention;
Fig. 32 is a sectional view showing a fifth embodiment of an ion source in accordance with the present invention;
Fig. 33 is a diagram illustrating a state of generated plasma in the embodiment shown in Fig. 32;
Fig. 34 is a sectional view showing a sixth embodiment of an ion source in accordance with the present invention; and
Fig. 35 shows a state of the generated plasma therein.

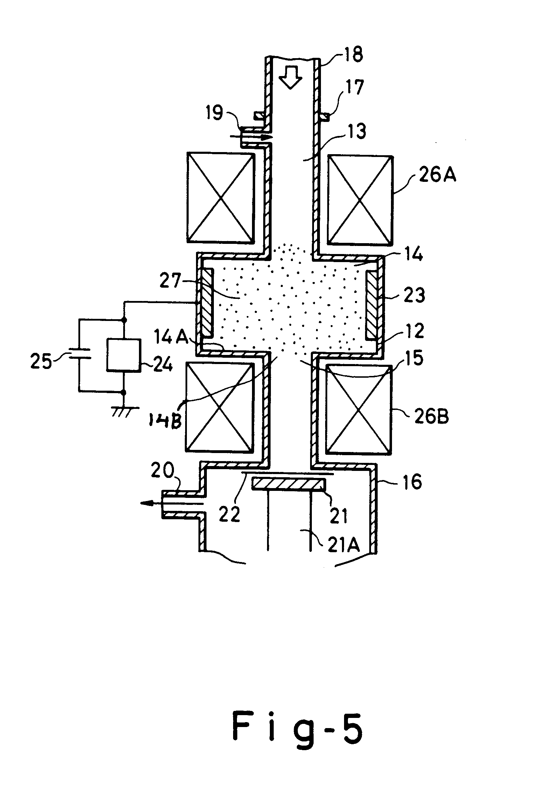

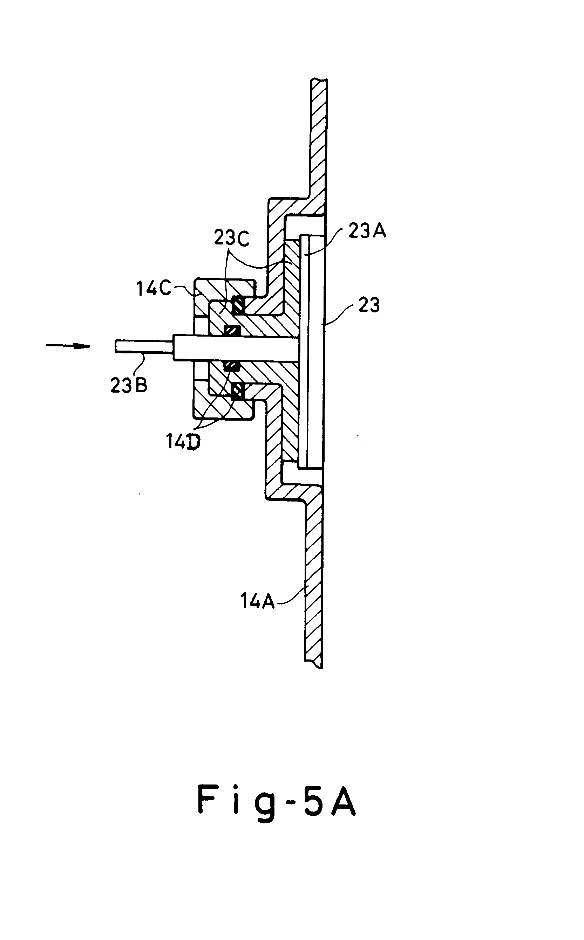

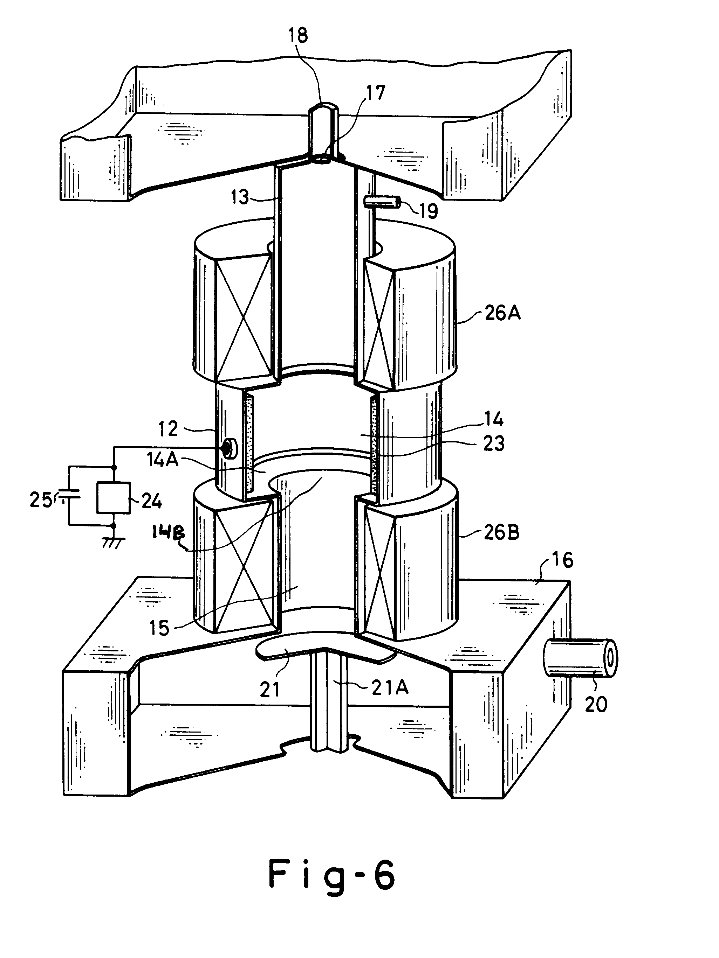

Fig. 5 is a sectional view showing a first embodiment of an ionization apparatus in accordance with the present invention and a thin film forming apparatus utilizing the above-mentioned ionization apparatus. Fig. 5A is a fragmentary view, on enlarged scale, thereof and Fig. 6 is a partial cutaway view in perspective showing the embodiment shown in Fig. 5. A vacuum chamber 12 made of a non-magnetic material such as stainless steel is composed of a vacuum waveguide 13, a plasma generation chamber 14, an end portion 15 of the plasma generation chamber 14 and a specimen chamber 16. The vacuum chamber 12 is provided with a microwave introduction window 17 and the microwave is supplied through a rectangular waveguide 18 from a microwave source connected to a microwave introduction mechanism consisting of a matching device, a microwave power meter, an isolator and so on (not shown). In this embodiment, the microwave introduction window 17 is a quartz glass plate and a magnetron at, for instance, 2.45GHz is used as the microwave source.

The plasma generation chamber 14 is water- cooled in order to prevent the temperature rise resulting from the plasma generation. A plasma generating gas is introduced through an inlet port 19 and the vacuum chamber 12 is evacuated through an outlet or exhaust port 20 by an evacuation device. A substrate 21 is supported by a substrate holder 21A located at the other end in opposing relationship with the microwave introduction window 17 and a shutter 22 is disposed above the substrate 22 which can be opened or closed so as to prevent the impingement of the sputtered particles on the substrate 21. The substrate holder 21A has a built-in heater which in turn heats the substrate 21. Furthermore, a DC or AC voltage can be applied to the substrate 21 so that a bias potential can be applied to the substrate upon which a thin film is being formed or the sputter cleaning of the substrate can be accomplished. In Fig. 6, the shutter 22 is not shown.

For the plasma generation chamber 14, as a microwave cavity resonator, for instance, the cylindrical cavity resonance mode TE11 ₃ is used and it consists of a cylinder 20 cm in inner diameter and 20 cm in height so that the electric field strength of the microwave can be increased and the efficiency of the microwave discharge can be improved. A cylindrical target 23 which can be water cooled is attached to a portion of the side surface of the plasma generation chamber 14 and a power source 24 can apply a negative voltage up to -1.5 kV and 10 A to the target 23. In this case, the target portion must function as a part of the resonator for the microwave, by this reason the target 23 is grounded through a capacitor 25 having a high electrostatic capacity. As shown in Fig. 5A, the target 23 is connected to a terminal 23B through a packing plate 23A which is incorporated with the target 23 and is electrically and thermally conductive and has such a construction that the cooling water circulates therein. The target 23 is electrically insulated from the side wall 14A of the plasma generation chamber 14 by an insulator 23C. The vacuum state in the plasma generation chamber 14 is maintained by vacuum-tight O rings 14D and a screw cap 14C. In Fig. 6, the packing plate 23A as well as the insulator 23C is not shown. Furthermore, in all the embodiments to be described hereinafter, they are not illustrated in detail because the disposition of the target within the plasma generation chamber is substantially similar to that in this embodiment. The lower end of the plasma generation chamber 14, that is, the surface 14A connected to the end portion 15 of the plasma chamber 14 is formed with a hole 14B 10 cm in inner diameter and the surface 14A serves as a reflection surface of the microwave, as a result the plasma chamber 14 functions as a cavity resonator.

Electromagnets 26A and 26B are fitted over the plasma generation chamber 14 at both the upper and lower ends thereof and the intensity of the magnetic fields produced by the electromagnets 26A and 26B is so controlled that the conditions for causing the electron cyclotron resonance due to the microwave can be established within the plasma generation chamber 14. For instance, the condition for causing the electron cyclotron resonance of the microwave at a frequency of 2.45GHz is the magnetic flux density of 0,0875Vsm-² (875G), accordingly both of the electromagnets 26A and 26B are so designed and constructed that a maximum magnetic flux density of 0,3Vsm-² (3000G) can be obtained. When the electromagnets 26A and 26B are spaced apart from each other by a suitable distance so that the magnetic flux density within the plasma chamber 14 is reduced to a minimum or when the so-called mirror magnetic field arrangement is established, the electrons can efficiently receive the energy due to the electron cyclotron resonance, and the scattering of the generated ions and electrons in the direction perpendicular to the magnetic field can be prevented and further the plasma 27 can be confined within the mirror field.

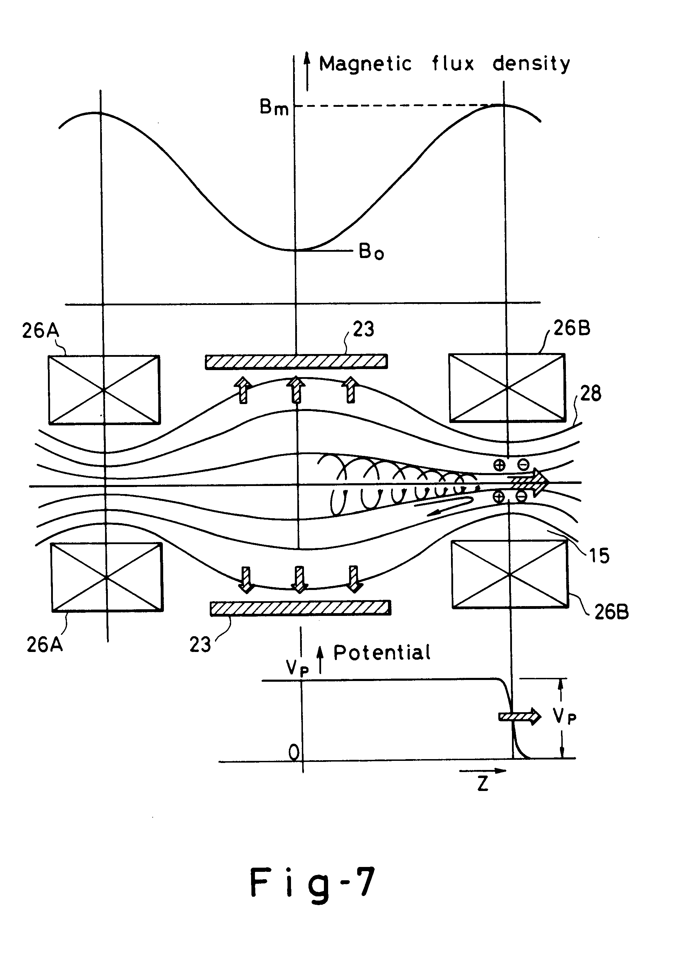

In Fig. 7 illustrating the underlying principle of the present invention, same reference numerals are used to designate similar parts shown in Fig. 5. Parameters in the case of the generation of plasma are a gas pressure in the plasma generation chamber, a power of the microwave, a voltage applied to the target, a gradient of the mirror magnetic field (the ratio Bm/Bo between the maximum magnetic flux density Bm of the electromagnet assembly and the minimum magnetic flux density Bo within the plasma generation chamber at the axis of the electromagnets 26A and 26B), a distance between the electromagnets and so on. For instance, in the case of the microwave at a frequency of 2.45GHz, the minimum magnetic flux density Bo is determined at 0,0875Vsm-² (875G) while the maximum magnetic flux density Bm at the midpoint of each electromagnet can be varied from 0,1 to 0,3Vsm-² (1 kG to 3 kG) so that the gradient of the magnetic field can be varied. When the magnetic field is gradually varied in the space, the charged particles in the plasma are constrained by the lines of magnetic force 28, make the spiral movement around the lines of magnetic force 28, and are reflected at a portion of high magnetic flux density while maintaining their angular momentum, as a result they reciprocate within the mirror magnetic field and are confined. In this case, the above-mentioned gradient of the mirror magnetic field or Bm/Bo greatly influences the plasma confinement efficiency. When a negative voltage is applied to the target faced to the high density plasma thus confined, the ions in the high density plasma can be efficiently extracted to the target 23, causing sputtering. In addition, a portion of almost all neutral particles sputtered from the target 23 is ionized in the high density plasma having high electron temperatures. The electrons are far lighter than the ions, so that the speed of the movement of the electrons in the direction of the lines of the magnetic force is faster than that of the ions. As a result, many electrons escape from the ends of the mirror while positive ions remain in the mirror therefore the charge separation occurs and consequently the electric fields are induced in the vicinity of the ends. When the potential difference (Vp) between the outside and the inside of the plasma generation chamber becomes equal to the average energy of the electrons, the equilibrium is attained and this electric field causes the deceleration of the electrons while causing the acceleration of the ions. Thus, the electrons and ions are emitted in the same amount. When the plasma is considered from the standpoint of the thin film forming apparatus, the losses due to the space charge effect by the mirror mean that the ions having the energy equivalent to the voltage difference can be obtained from the plasma. This energy is greatly dependent on the power of the microwave and the gas pressure and can be controlled freely in a wide range from several electron volts to hundreds electron volts.

Meanwhile, a portion of neutral particles sputtered from the target 23 is directly deposited over the substrate 21. These particles are such particles as move in the direction of the substrate 21 and did not encounter any collision with other particles during their movement. Furthermore, sputtered atoms or molecules consisting of the target material lose their kinetic energy while reciprocating in the plasma and finally diffuse out to the outside of the plasma by crossing the lines of magnetic force. The diffused neutral particles are deposited on the surface of the substrate, thereby forming a thin film. As described above, the target and the substrate are located at the positions perpendicular to each other, so that the bombardment on the substrate of the negative ions from the target and high-energy Ar neutral particles, which are a few percent of the sputtered neutral particles, can be avoided. As a consequence, the problem encountered in the conventional sputtering processes that the bombardment on the substrate by various high-energy particles can be prevented.

In addition, there exists the scattering of particles due to the collisions of the particles in the plasma, and the relaxation time of the decrease of the plasma density due to the collisions and scattering of the particles becomes shorter as the energy of ions in the plasma is low. Therefore, the average energy of the particles escaping from the ends of the mirror becomes only a fraction of the average energy of the particles within the plasma. In other words, this means that the ionization in the plasma is carried out at a high-energy (in a highly active mode), and when the ions thus obtained are extracted from the plasma to form a film, the ions can be extracted with the lower energy at fraction of the average energy described above and shows that the sputtering apparatus with the above-described magnetic field distribution has most preferable properties when used as the thin film forming apparatus.

According to the present invention, since the plasma is activated, the stable discharge can be maintained at a lower gas pressure 0,001 Pa (10-⁵ Torr) and a film containing less impurities can be formed.

Furthermore, according to the present invention, the heating due to the electron cyclotron resonance is utilized, so that the electron temperature in the plasma can be freely controlled. Therefore, the electron temperature can be increased to such an extent that highly charged ions can be produced. Accordingly the present invention has a remarkable feature that materials which are chemically unstable can be synthesized by utilizing the highly charged ions.

Meanwhile, in the case of the thin film forming apparatus in accordance with the present invention, the ionization ratio in the plasma is remarkably high as described above, and the sputtered neutral particles emitted from the target are ionized at a high rate in the plasma and the ionized particles which had constituted the target are accelerated by the potential of the target. As a consequence, the so-called self-sputtering rate, that is, the rate at which the target is sputtered by these accelerated ionized particles is increased considerably. That is, even when a plasma generation gas (for instance, Ar) is extremely thin or even when no plasma generating gas is used, the above-described self-sputtering continues, consequently the present invention has a marked feature that a film of an extreme purity can be formed.

Next, the results of the formation of an AI film by the thin film forming apparatus in accordance with the present invention will be described. The specimen chamber 9 was evacuated to a vacuum of the order of 7 x 10-⁵ Pa (5 x 10-⁷ Torr) and then Ar gas was introduced into the chamber 9 until the plasma formation chamber has a pressure of the order of 0,04 Pa (3 x 10-⁴ Torr). Thereafter, a film was formed under the conditions that the microwave power was 100 - 800 W, the voltage applied to the AI target was -300 V to - 1 kV and the gradient of the mirror magnetic field was maintained at 0,2/0,08 Vsm-² (2 kG/875 G). In this case, the substrate holder was disposed at the lower end of the lower mirror coil and the sputtering process was started at room temperature without heating the substrate. The film formation rate was increased with the increase of the microwave power and the voltage applied to the target and was 25nm/min (250 A/min) when the microwave power was 300 W and the negative voltage applied to the target was -800 V. When the microwave power and the voltage applied to the targets were varied within the above-described ranges, respectively, the thin films were formed efficiently at the thin film deposition rate of 10-200nm/min (100 - 2000 A/min). As compared with the thin films formed by the conventional sputtering techniques, the internal stresses in thin films were low, as a result thin films more than 2 _{/1}.m in thickness could be formed in a stable manner without causing cracking and separations.

In this case, the average energy of ions varies between 5 eV and 25 eV and of all particles emitted in the direction of the substrate, the ratio of the ions was between 10 and 30%.

According to the thin film formation apparatus in accordance with the present invention, not only AI films but also almost all desired thin films can be obtained and furthermore, when a reactive gas is introduced into the process chamber, the reaction sputtering can be realized.

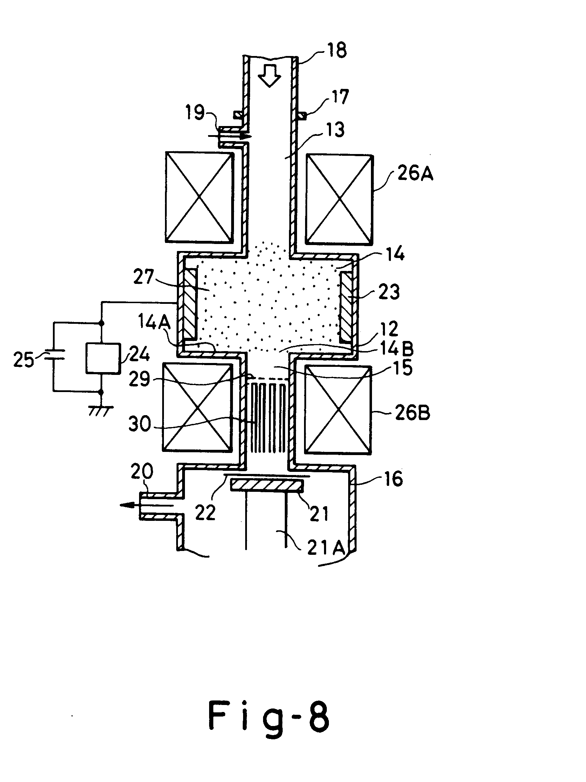

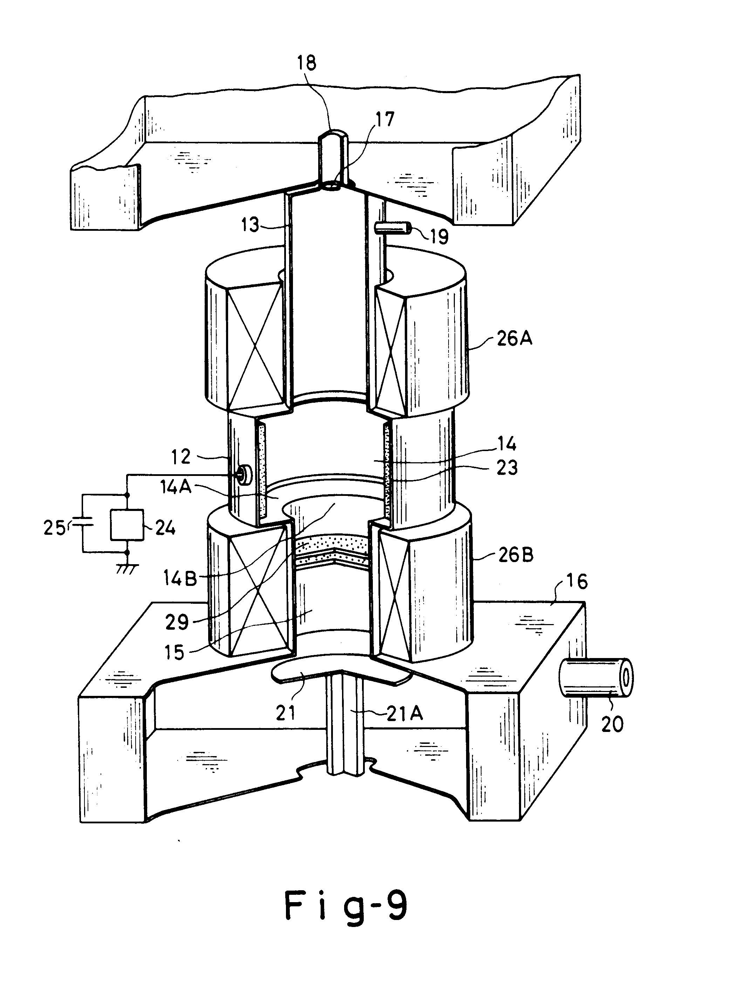

The devices as shown in Figs. 5 and 6; that is, the ion generation apparatus utilizing a high density plasma sputtering can be also used as an ion source. Fig. 8 is a sectional view of an embodiment of the ion source while Fig. 9 is a partial cutaway view in perspective thereof. Same reference numerals used in Figs. 5 and 6 are also used to designate similar parts in Figs. 8 and 9. The main differences between this embodiment and the apparatus shown in Figs. 5 and 6 reside in the fact that an ion extraction grid 29 is disposed within the end portion 15 of plasma generation chamber. In this embodiment, the bottom surface 14A of the plasma generation chamber 14 is formed with a hole 10cm in diameter and functions as a reflecting surface for the microwaves and the plasma generation chamber 14 functions as a cavity resonator. The grid surface in opposing relationship with the microwave introduction window also functions as a reflecting surface of the microwaves so that the efficiency of the microwave discharge is increased.

In this embodiment, the confinement of the plasma, the sputtering of a target 23 and the ionization of the sputtered particles are substantially similar to those described above with reference to the previous embodiment and a large amount of ions of atoms or molecules which had constituted the target are generated in the high density plasma. These ions thus generated are extracted through the grid 29 as high current ion beams 30 and the energy of the ions thus extracted can be controlled between several electron volts and dozens kilo electron volts by controlling the voltage applied to the grid 29. A great amount of ions having a suitable level of energy can be extracted and almost all the particles thus extracted are ionized.

Furthermore, in the apparatus of the present invention, the ionization is carried out by the sputtering technique utilizing high density plasma, so that various metal ions and the ions of various chemical compounds having an extremely high current density can be obtained. Therefore, the above-described apparatus in accordance with the present invention exhibits excellent feature, when it is used as an ion source for forming various thin films or etching thereof.

In addition, according to the present invention, the plasma is made active, so that the discharge can be accomplished in a stable manner at a lower gas pressure 0,001 Pa (10-⁵ Torr). Therefore, the present invention has a feature that the ions with less impurities can be extracted.

Furthermore, the present invention utilizes heating by the electron cyclotron resonance, so that the temperatures of the electrons in the plasma can be freely controlled. Therefore, the electron temperature rises to such an extent that highly charged ions can be generated. Thus, the present invention has a further feature that the highly charged ions are extracted to synthesize compounds which are chemically unstable.

Meanwhile, in the case of the ion source in accordance with the present invention, since the ionization ratio in the plasma is extremely high as described above, the ratio of the ionization in the plasma of the sputtered neutral particles emitted from the target is high and these ionized particles, which had constituted target, are accelerated due to the potential applied to the target so that they sputter the target again. In other words, the so-called self-sputtering ratio is extremely increased. More particularly, even in the case that the plasma generation gas (for instance, Ar) is very thin or no plasma generation gas is used, the above-described self-sputtering continues. Therefore the present invention has a further feature that the ions with a high degree of purity can be extracted and a thin film can be formed with these ions thus extracted.

Next, the results of the formation of AI films by the apparatus of the present invention will be described. After the plasma generation chamber had been evacuated to a vacuum of the order of 7 x 10-⁵ Pa (5 x 10-⁷ Torr), Ar gas was introduced until the gas pressure in the plasma generation chamber becomes 0,04 Pa (3 x 10-⁴ Torr). Under the conditions that the microwave power was 300 W, the voltage applied to the AI target was -800 V and the gradient of the mirror field was maintained at 0,2/0,0875Vsm-² (2kG/875G), the voltage of -70V was applied to the ion extraction grid, an AI film was formed at the deposition rate of 70 A/min. Under the conditions that the microwave power was between 100 and 800 w, the voltage applied to the target was -300 V to - 1 kV and the gradient of the mirror field was maintained at 0,2/0,0875Vsm-² (2kG/875G), aluminum ions (AI⁺) having the energy ranging from 20 eV to 100 eV were extracted and a film was formed efficiently at the deposition rate of from 50 to 1000 A/min.

The ion source in accordance with the present invention can be used as an ion source for not only forming aluminum films but also almost all other various films and for etching thereof. Furthermore, when a reactive gas is introduced into the plasma generation chamber, the deposition due to the ion beam of a compound can be realized.

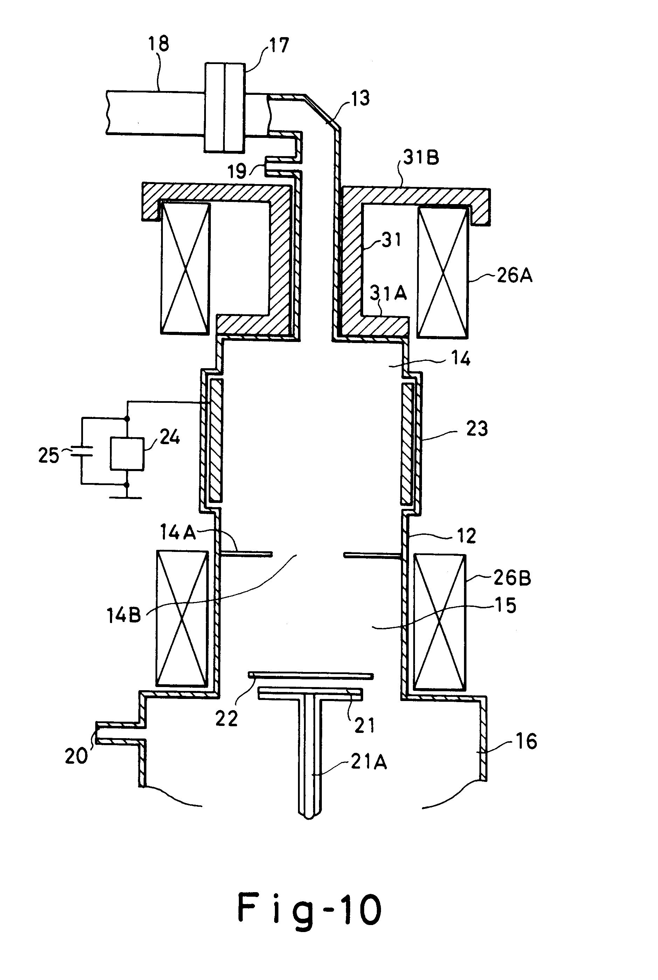

Fig. 10 is a sectional view showing another embodiment of a thin film forming apparatus in accordance with the present invention. When the thin film forming apparatus as shown in Figs. 5 and 6 are used in order to deposit a thin film material such as a metal or an electrically conductive material, the film is deposited not only over the substrate but also the microwave introduction window made of a quartz or the like, therefore the microwave for generating plasma is reflected back from the microwave introduction window and therefore it becomes difficult to generate plasma. As a result, in the case of the apparatus shown in Fig. 5 or 6, it becomes impossible to form an electrically conductive film in a stable manner for a long period of time and the materials to be used and the thickness of a film formed are limited. This embodiment is intended for resolving the above described problem. In this embodiment, a yoke 31 made of, for instance, a soft magnetic iron is disposed around the vacuum waveguide 13 in order to absorb the magnetic fluxes, which is produced by the electromagnet 26A arranged in such a way that a valley of the magnetic field is defined within the plasma generation chamber 14, and reduces the intensity of the magnetic field within the vacuum waveguide 13. The vacuum waveguide itself may be made with a suitable yoke material. In addition, in order to define the distribution of the magnetic field produced by the yoke 31 within the plasma generation chamber as uniformly as possible, a portion 31A opposed to the top surface of the plasma generation chamber 14 is enlarged as much as possible. Furthermore, when the other end 31 B of the yoke 31 is arranged so as to surround the upper end of the electromagnet 26A and absorb the magnetic flux so that the magnetic resistance of the electromagnet 26A itself is reduced, it becomes possible to attain a high degree of yoke effect. In this embodiment, the vacuum waveguide 13 is in the form of an L and the microwave introduction window 17 is disposed at a position which cannot been directly viewed from the cylindrical target 23 mounted in the plasma generation chamber 14. The remaining construction is substantially similar to that described above in conjunction with Fig. 5.

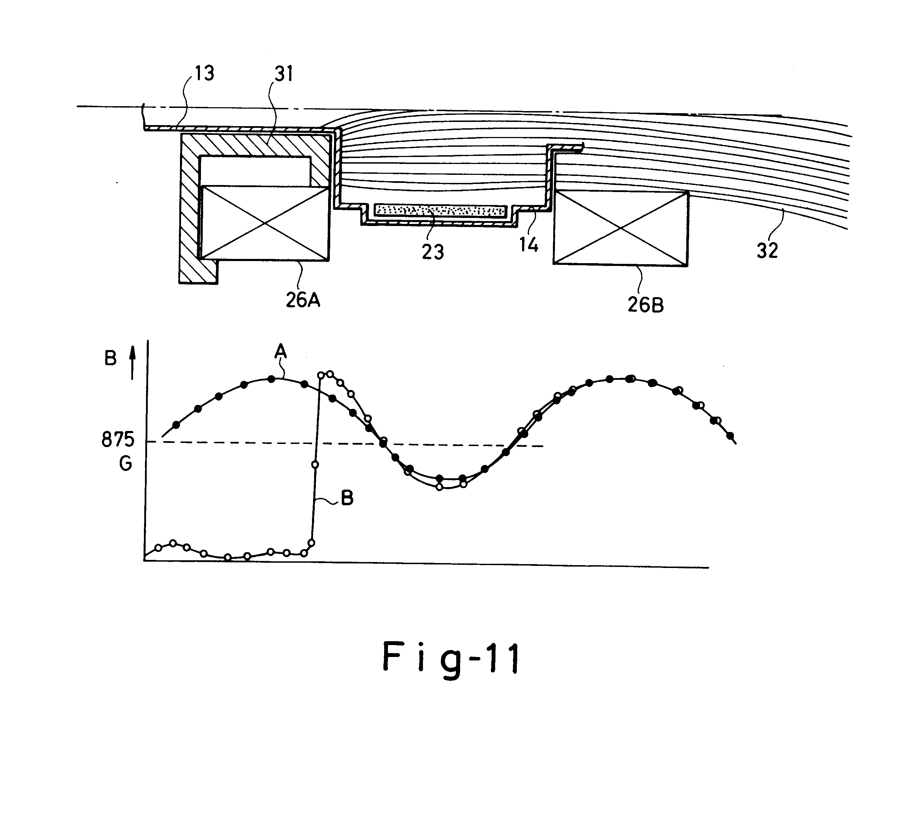

As in the cases of the embodiment shown in Figs. 5 and 6, one or more electromagnet pairs 26A and 26B are disposed at both ends of the plasma generation chamber 14 so that the valley of the intensity of the magnetic field produced by the electromagnets 26A and 26B is defined in the plasma chamber 14. In this case, the conditions for attaining the electron cyclotron resonance (ECR) in the plasma generation chamber 14 must be satisfied. Because of ECR, the energy is efficiently imparted to the electrons, as a result high density plasma can be produced at a low gas pressure in the plasma generation chamber 14. A vacuum waveguide 13, which is disposed on the upper stream of the microwave generation chamber, is surrounded by the magnetic flux absorbing yoke 31 so that the magnetic field is distributed so as to change the intensity of the magnetic field abruptly at the boundary between the vacuum waveguide 13 and the plasma generation chamber 14. Fig. 11 shows an example of the distribution of the intensity of the magnetic field in the direction of the magnetic flux in this embodiment. In Fig. 11, the magnetic field distribution indicated by the curve A is defined when the vacuum waveguide 13 is not surrounded with the yoke 31 while the distribution of the magnetic field indicated by the curve B is defined when the vacuum waveguide 13 is surrounded with the yoke 31.

A cylindrical target 23 is attached to the cylindrical inner wall surface of the plasma generation chamber 14 in such a way that it surrounds the plasma or one or more flat targets are attached to the inner wall surface of the plasma generation chamber 14 so as to face to the plasma therein.

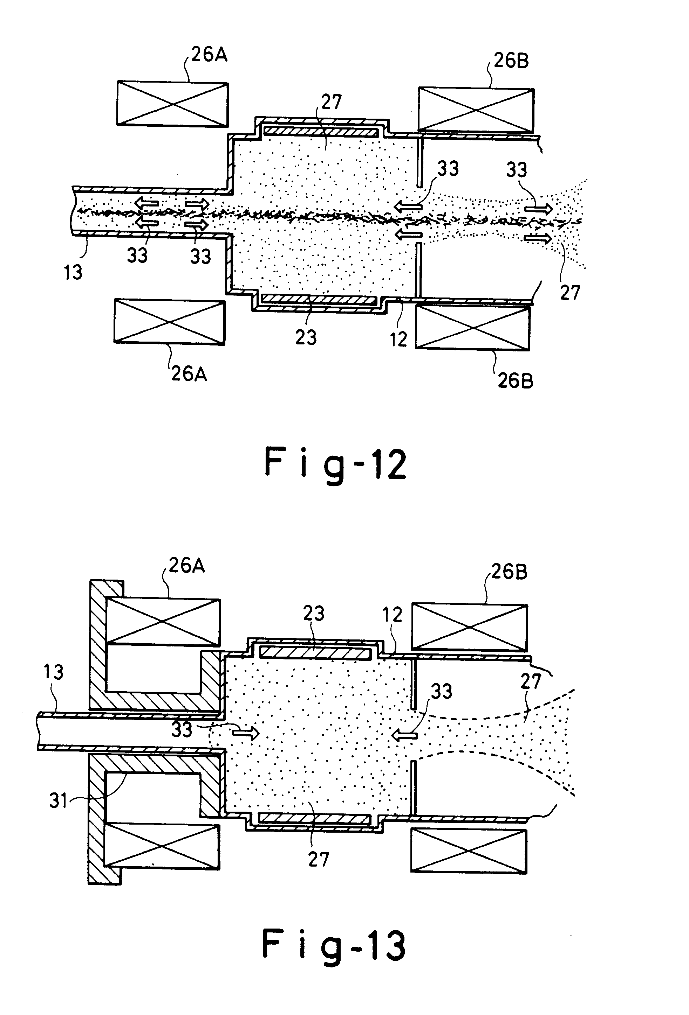

Fig. 12 shows the plasma generation mode and the accelerated directions of the plasma generated when no yoke 31 is used while Fig. 13 shows the plasma generation mode and the directions in which the generated plasma is accelerated when yoke 31 is used. In the mode of the generation of plasma, parameters are the gas pressure in the plasma generation chamber, microwave power, power applied to the target, gradient of the magnetic field and so on. In this case, when the microwave at a frequency of 2.45GHz is used, it suffices that the magnetic flux density 0,0875Vsm-² (875G) which is one of the conditions for producing the resonance as described above, is attained within the plasma generation chamber and the distribution of the gradient of the mirror field is so defined that the intensity of the magnetic field has a valley within the plasma generation chamber. When the magnetic field is gradually varied in the space as described above, the electrons produced in a high density plasma have a far higher mobility than that of ions, and are accelerated toward the center portion of the plasma generation chamber while being constrained by the magnetic fluxes 32 so as to make the spiral movements around the magnetic fluxes without losing the angular momentum. As a result, the charged particles in the plasma generation chamber are caused to reciprocate in the valley of the magnetic field and in this reciprocal motion heating of the the electrons and the ionization of the particles are promoted. However, the electrons having a high degree of mobility lose their energy gradually and leak at the ends of the plasma in the direction of the magnetic flux so that only the positive ions remain in the plasma, and naturally an electric field is induced by this charge separation. The electric field thus induced causes the positive ions in the plasma to accelerate in the direction of the substrate. In practice, the independent behavior of the electrons and the ions destroys the neutrality of the plasma and they cannot behave so. The equilibrium is attained when the difference in potential between the surface of the substrate and the plasma becomes equivalent with the average energy of the electrons and this electric field acts as a deceleration field for the electrons but for the ions acts as an acceleration field, as a result the so-called ambipolar diffusion mode in which the amounts of emitted electrons and ions become substantially equal to each other is attained. As a consequence, the ions each having a relatively low energy between several electron volts and several tens electron volts can be extracted. Furthermore, when a negative voltage is applied to the target disposed in opposing relationship with the high density plasma generated by ECR, the ions in the high density plasma can be efficiently extracted so that sputtering can be carried out. The sputtered target material is extracted in the manner described above and a thin film can be formed on the substrate.

In the case of the formation of an electrically conductive film, when the microwave introduction window becomes dim because of the diposition of the material the microwave is reflected from the dim window, so that the plasma cannot be produced for a long period of time. Therefore, in order to prevent the microwave introduction window 17 from becoming dim by the deposition of an electrically conductive material, it may be proposed that the microwave introduction window 17 is disposed at a position spaced apart from the plasma generation chamber 14 and is connected thereto through the vacuum waveguide 13. However, as indicated by the curve A in Fig. 11, when only the vacuum waveguide 13, which is not surrounded by the yoke 31, is used the magnetic flux density which satisfies ECR conditions is attained within the vacuum waveguide 13 and plasma is generated therein. As a result, the microwave power can not be supplied to the plasma chamber 14 effectively and non-uniform plasma is generated. Concurrently, since the diverging magnetic field is produced in the direction from the vacuum wageguide 13 to the microwave introduction window, the plasma 27 is accelerated not only in the direction of the the substrate 21 but also in the direction of microwave introduction window. On the other hand, as indicated by the curve B in Fig. 11, when the vacuum waveguide 13 is surrounded with the yoke 31, plasma is not produced in the vacuum waveguide and there exits an abrupt variation in the intensity of magnetic field between the vacuum waveguide 13 and the plasma generation chamber 14, as a result the plasma is not accelerated in the direction of the microwave introduction window 17. Of the particles sputtered from the cylindrical target 23, the particles which are not ionized and therefore neutral are not affected by the magnetic field as well as the electric field and travel straightly from the target 23. However, the microwave introduction window 17 is disposed at the position which can not be directly viewed from the target 23; that is, the position downstream of an obstacle upon which inevitably all the particles flying straightly from the target 21 impinge, so that the microwave introduction window 17 is prevented from becoming dim with the sputtered particles. As a result, even when the sputtering process is carried out for a long period of time, the microwave introduction window will not become dim. Furthermore, the films of almost all the materials can be continuously formed for a long period of time in a stable manner regardless of the electric conductivity and the thickness of the film being formed.

In addition, when the yoke 31 is considered as a component part of the magnetic circuit of the electromagnet 26, the yoke 31 has an effect for decreasing the magnetic resistance of the electromagnet 26A itself. Thus, this embodiment has one of the important features in practice that the value of the current which is made to flow through the electromagnet 26A for attaining the magnetic flux density required for ECR is by far lower than the value of the current made to flow through the electromagnet 26A which is not provided or surrounded with the yoke 31.

By using the apparatus of this embodiment, under the same conditions as those described above with reference to Fig. 5, the AI film could be deposited at the deposition rate of 10-80 nm/min (100-800 A/min) for a long period of time in a stable and efficient manner. It should be noted here that in the case of the embodiment shown in Fig. 5, the magnitude of the current made to flow through the electromagnet was of the order of 28 A, but in this apparatus, the required magnitude of the current suffices the order of 16 A because of the effect of the yoke 31. In this case, the average energy of the ions could be varied from 5 eV to 30 eV.

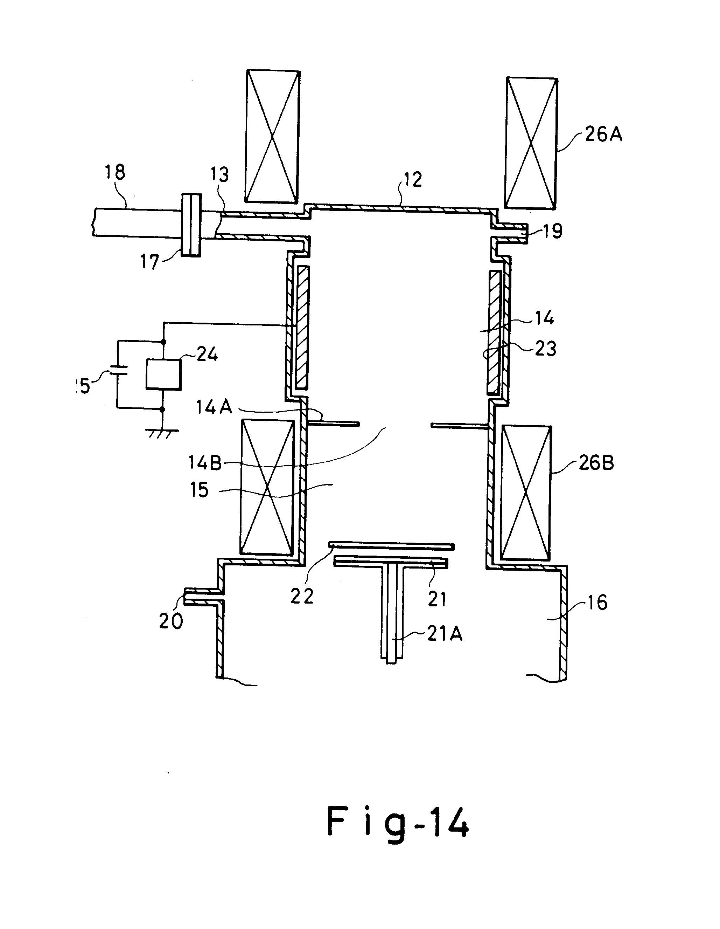

Fig. 14 shows a third embodiment of a thin film forming apparatus in accordance with the present invention.

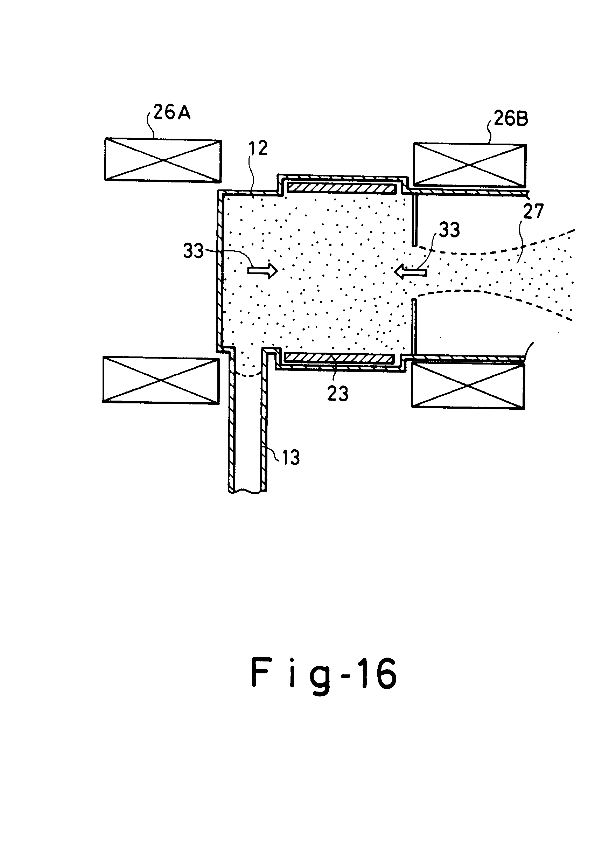

In this embodiment, the vacuum waveguide 13 is connected to the plasma generation chamber 14 perpendicular to the magnetic fluxes produced by the magnets 26A and 26B and the microwave introduction window 17 made of a quartz plate is disposed at a position which cannot be directly viewed from the target 23 mounted in the plasma generation chamber. The remaining construction is substantially similar to that of the embodiment described above with reference to Figs. 5 and 6. Fig. 16 shows the plasma production mode and the acceleration directions 33 of the plasma.

As shown in Fig. 12, when the vacuum waveguide 13 is connected to the plasma generation chamber 14 in parallel with the magnetic fluxes produced by the magnets 26A and 26B, the diverging magnetic field is formed in the direction of the introduction of the microwaves through the vacuum waveguide 13, so that the plasma is accelerated not only in the direction of the substrate but also in the direction of the microwave introduction window. On the other hand, when the vacuum waveguide 13 is connected to the plasma generation chamber 14 perpendicular to the magnetic fluxes, the plasma would not cross or transverse the magnetic fluxes and would not diverge, so that the plasma would not be accelerated in the direction of the microwave introduction window. Furthermore of the particles sputtered from the cylindrical target 23 mounted in the plasma generation chamber 14, the neutral particles which are not ionized are not affected by the magnetic and electric fields, but travel or fly substantially straightly from the target. Therefore, by disposing the microwave introduction window 17 at the position which cannot be directly viewed from the target 23 as described above, the microwave introduction window 17 can be prevented from becoming dim by the sputtered particles. It follows therefore that it is preferable to form at least one bend in the vacuum waveguide 13. Thus, by utilizing this embodiment, films of almost all materials can be formed continuously for a long period of time in a stable manner regardless of the electric conductivity of a film being grown and the thickness thereof without causing dim of the microwave introduction window.

Next, the results of the formation of AI films by this embodiment will be described. First the specimen chamber 16 was evacuated to 7 x 10-⁵ Pa (5 x 10-⁷ Torr) and then Ar gas was introduced at a flow rate of 5cc/min until the gas pressure in the plasma chamber 14 becomes 0.07 Pa (5 x 10-⁴ Torr). Thereafter, under the conditions that the microwave power was between 100 and 500 W, and the power applied to the cylindrical AI target 23 was between 300 and 600 W, the film was formed at a gradient of the mirror field. In this case, the substrate holder was not heated and the film formation was carried out at room temperature. Under these conditions, the AI films can be deposited at a rate of deposition of 10-80 nm/min (100-800 A/min) continuously for a long period of time in a stable and efficient manner.

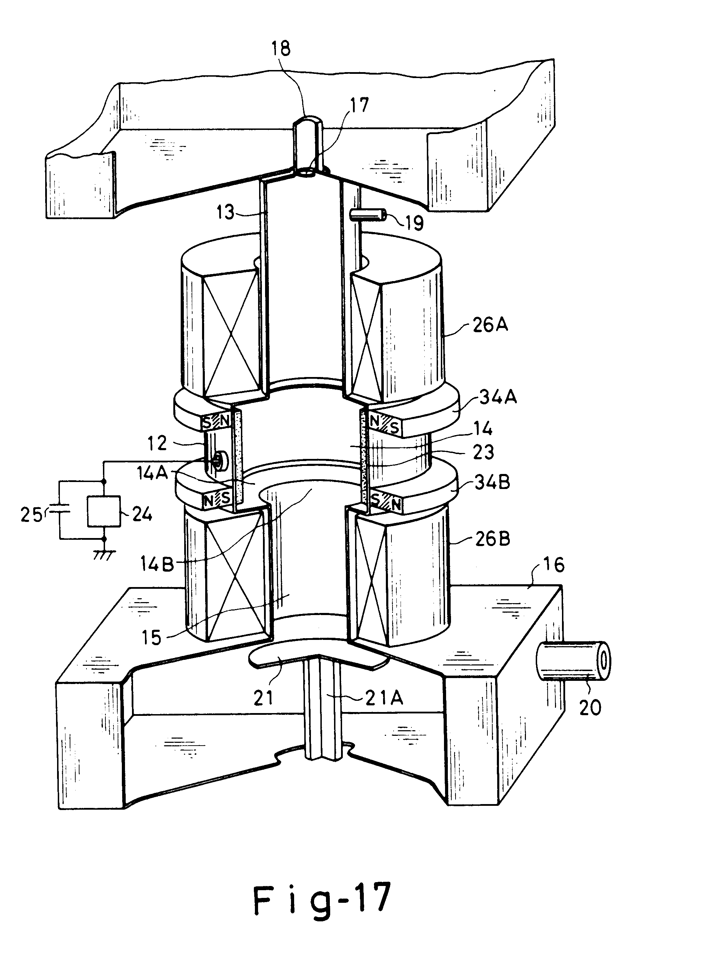

Referring next to Fig. 17, a fourth embodiment of a thin film forming apparatus in accordance with the present invention will be described. In this embodiment, at least one pair of ring-shaped permanent magnets 34A and 34B are disposed around the plasma generation chamber 14 at the positions corresponding to the upper and lower ends of the cylindrical target 23 in such way that the polarities of the magnets 34A and 34B are in opposed relationship with each other so that the magnetic fluxes will leak to the inner surface of the cylindrical target. The remaining construction is substantially similar to the embodiment described above with reference to Fig. 6. In Fig. 17, a shutter disposed above the substrate 21 is not shown for the sake of simplicity.

In this embodiment, the plasma is confined in a manner substantially similar to that described above in conjunction with Figs. 5 and 6. When the negative voltage is applied to the cylindrical target which is opposed to the confined high density plasma, the ions in the high density plasma are efficiently extracted and made to impinge on the inner surface of the cylindrical target, thereby causing the sputtering thereof. When the extracted ions impinge on the inner surface of the cylindrical target, the secondary electrons are emitted from the surface of the target are and accelerated away from the target with the high-energy corresponding to the voltage applied to the target. These secondary electrons have high energies and affect greatly the ionization effect of a gas.

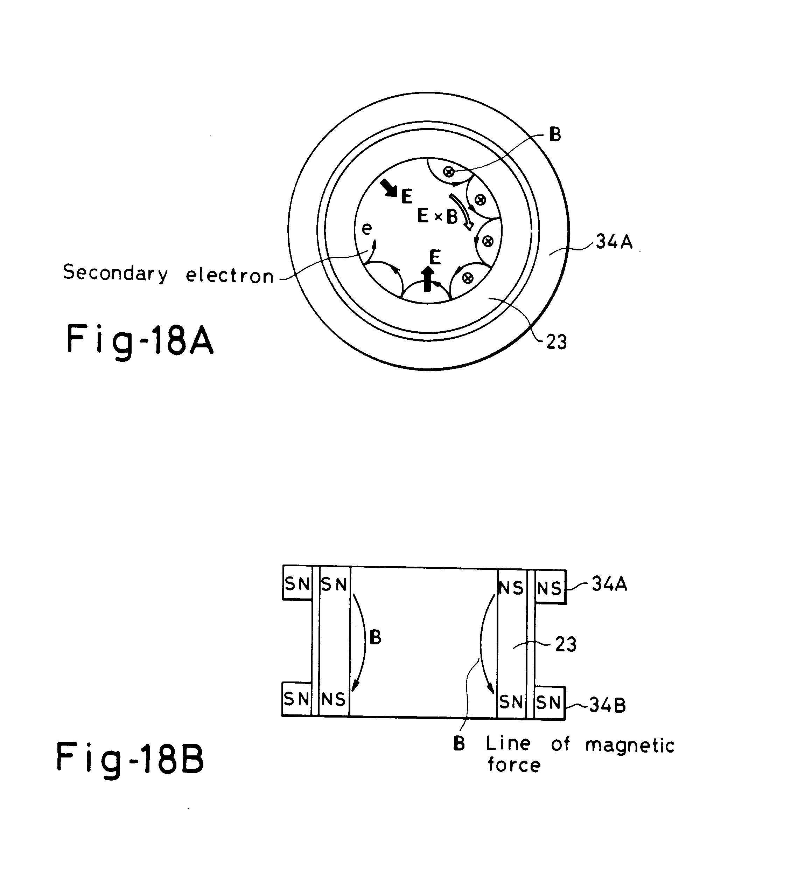

Meanwhile, the ring-shaped permanent magnets 34A and 34B disposed around the plasma generation chamber corresponding to the upper and lower ends of the cylindrical target with opposing polarity relationship with each other cause the leakage of the magnetic field B which in turn effectively confines the secondary electrons. The underlying principle of this phenomenon will be described with reference to Fig. 18A showing the horizontal cross section of the plasma chamber 14 and Fig. 18B illustrating the vertical sectional view thereof.

Secondary electrons, which are accelerated by the electric field J5 produced over the surface of the target by the voltage applied to the target, are deflected by the magnetic field J3 and are forced to return to the target. However, they are accelerated in the opposite direction by the electric field |E. While repeating the above-mentioned motions the high-energy secondary electrons drifted in the IE x J3 direction; that is, in the circumference direction of the inner circle of the target, and during these processes they repeatedly collide with the neutral particles. As a result, the highly efficient ionization of gas and hence the highly efficient sputtering can be accomplished at a lower voltage applied to the target.

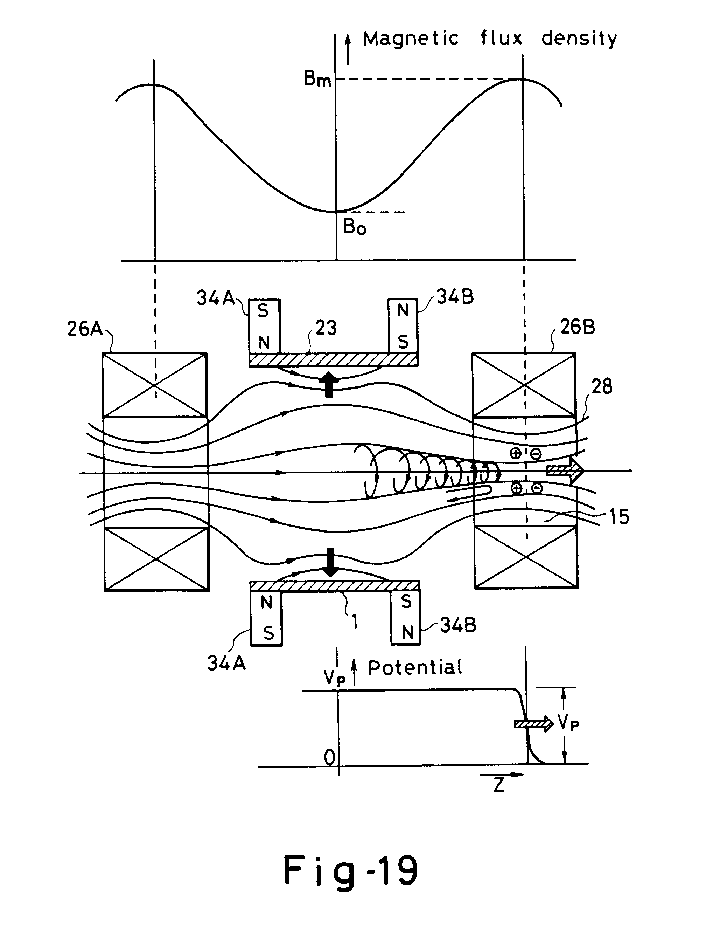

Fig. 19 is a diagram illustrating the motions of the electrons and ions in this embodiment. Fig. 19 is similar to Fig. 7 except that the permanent magnets 34A and 34B are disposed so that distribution of the lines of magnetic force varies at the most outer side. As described before, when many electrons escape from one end of a mirror magnetic field the positive ions remain in the mirror magnetic field, as a result the charge separation results, and then the electric field is induced naturally in the vicinity of the end. The equilibrium is attained when the potential difference (Vp) between the inner and outer potential becomes equivalent to the average energy of the electrons. Since the electric field decelerates the electrons but accelerates the ions, the amounts of emitted electrons and ions become substantially equal to each other.

Next, the results of the formation of AI films by this embodiment will be described. First, the specimen chamber 9 was evacuated to 5 x 10-⁵ Pa (5 x 10-⁷ Torr) and then Ar gas was introduced into the plasma generation chamber until the gas pressure therein rises 0.04 Pa (3 x 10-⁴ Torr). Under the conditions that the microwave power was between 100 and 800 W, the voltage applied to the AI target was -300 V to -1 kV, the magnetic flux density at the surface of the target was maintained at 4 x ₁0-²Vsm-² (400G) and the gradient of the mirror magnetic field was maintained 0,2/7 x 10-²Vsm-² (2kG/700G), the films were formed. In this case, the substrate holder was disposed at the lower end of the lower mirror coil and was not heated. Then the sputtering process was started and the thin films were efficiently formed at the deposition rate of 10-280 nm/min (100 - 2800 A/min). As compared with the film formation processes under the same conditions except that the permanent magnets 34A and 34B are not provided, the same deposition rate was obtained by applying a voltage to the target which was about 70% of the voltage applied to the targets in the comparison processes. Therefore, a film of 2 _{/1}.m or more in thickness can be formed in a stable state without cracking and exfoliation because the internal stresses in the film are lower as compared with the films formed by the prior art sputtering processes. In this case, the average energy of the ions varies from 5 eV to 25 eV and 10 - 30% of the particles traveling toward the substrate were ions.

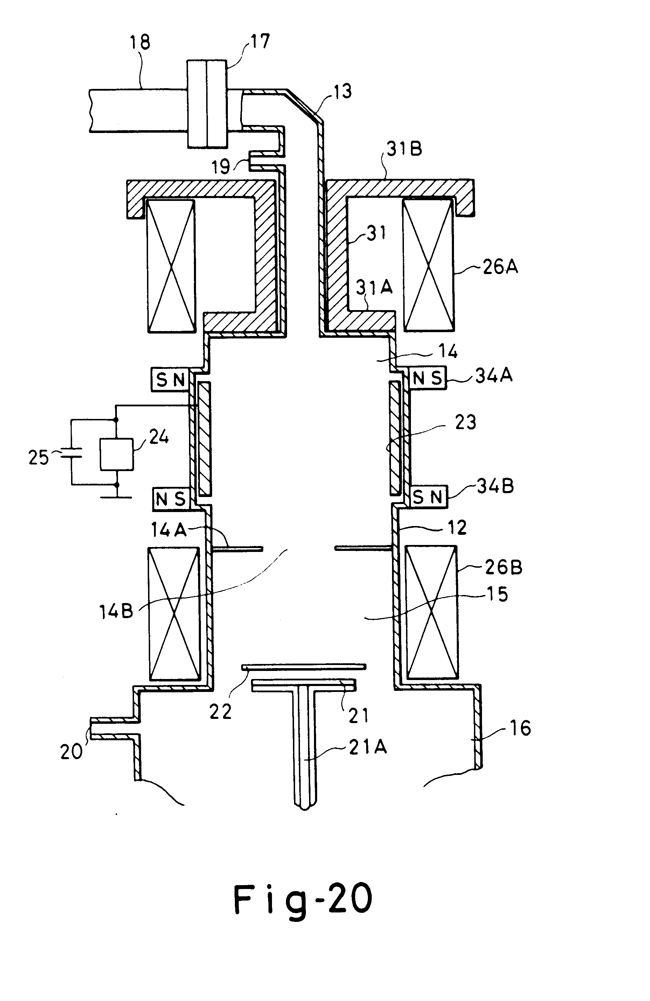

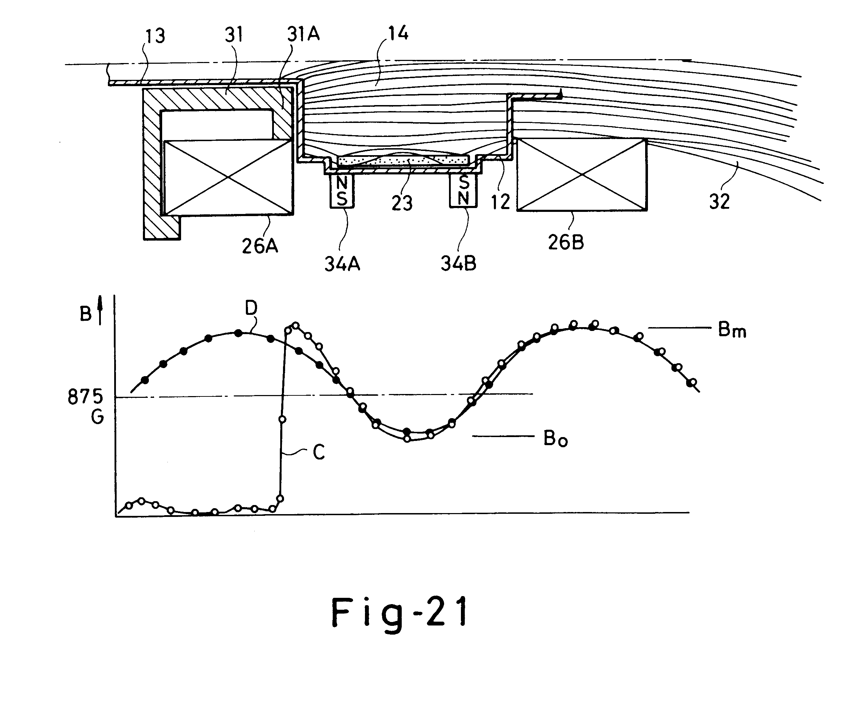

Next referring to Fig. 20, a fifth embodiment of a thin film forming apparatus according to the present invention will be described. It is equipped not only with a yoke 31 described above with reference to Fig. 10 but also with permanent magnets 34A and 34B described above in the conjunction with Fig. 17. Except these component parts, this embodiment is substantially similar in construction to the embodiment described above with reference to Figs. 5 and 6. The distribution of the intensity of the magnetic field in the direction of the magnetic flux is shown by the curve C in Fig. 21 while the distribution in case of using no yoke is indicated by the curve D. As in the case of the curve B in Fig. 11, the distribution of the intensity of magnetic field of this embodiment (the curve C) abruptly varies between the vacuum waveguide 13 and the plasma generation chamber 14. As a result, as described above with reference to Fig. 13, the plasma is not accelerated in the direction of the microwave waveguide, and accordingly the microwave introduction window 17 is prevented from being dimmed.

In this embodiment, since the permanent magnets 34A and 34B are provided as in the case of the embodiment shown in Fig. 17, it is possible to form a thin film at a high deposition rate and at a lower voltage applied to the target.

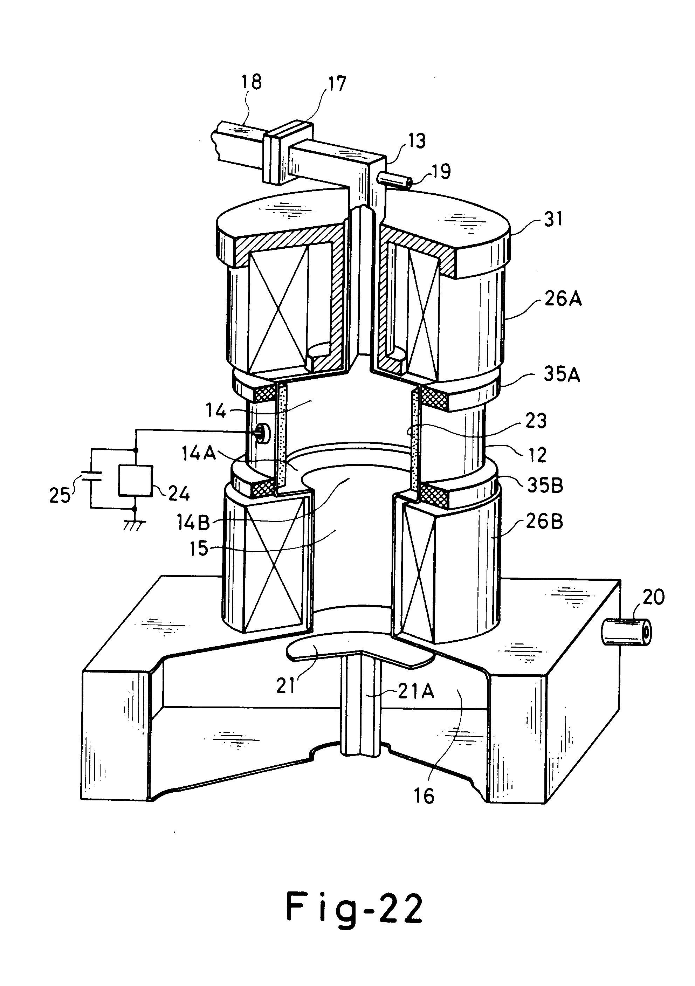

Fig. 22 shows a sixth embodiment of a thin film forming apparatus in accordance with the present invention. In this embodiment, the permanent magnets 34A and 34B are replaced by yokes 35A and 35B made of, for instance, soft magnetic iron. The yokes 35A and 35B converge the magnetic flux of the electromagnets 26A and 26B, respectively, and in turn cause to leak the magnetic fluxes to the surface of the target 23. The effect attained is substantially similar to that obtained by the provision of the permanent magnets 34A and 34B.

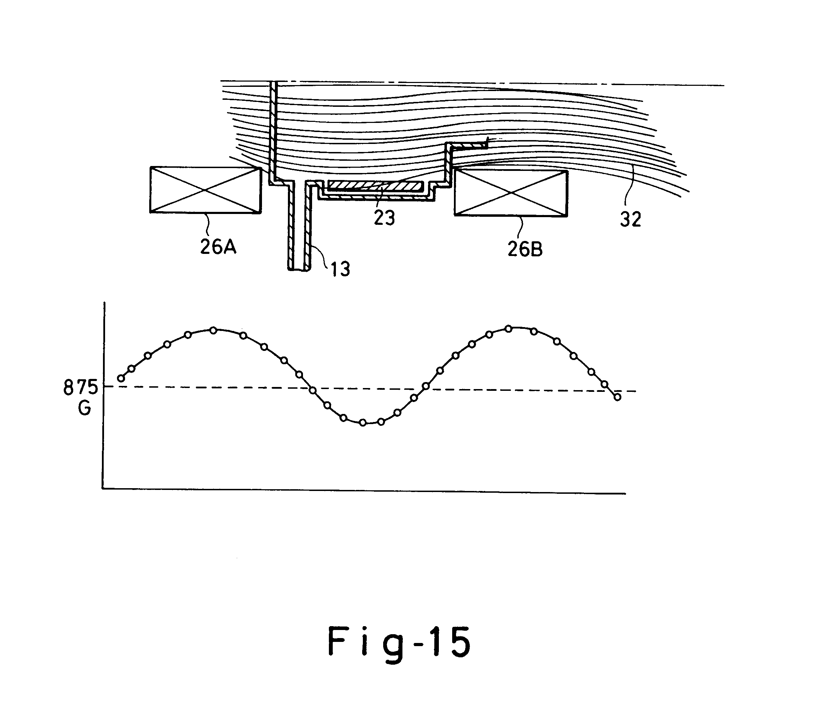

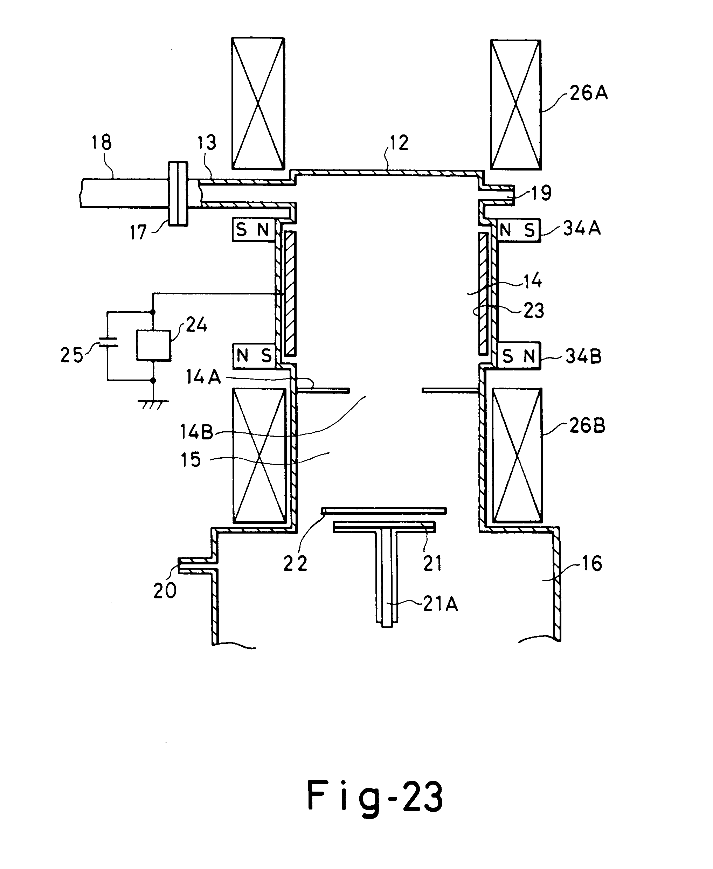

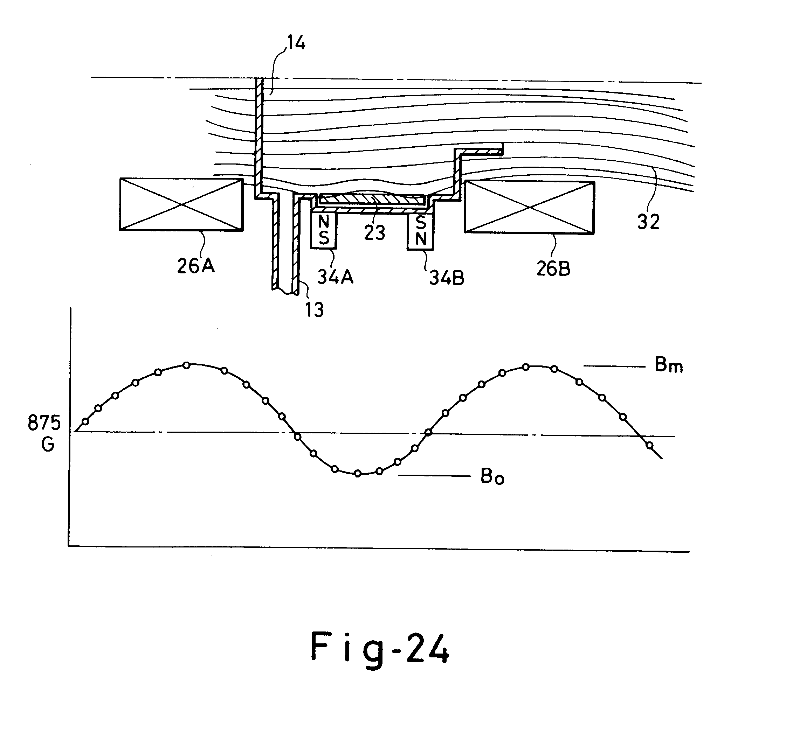

Fig. 23 shows a seventh embodiment of a thin film forming apparatus in accordance with the present invention. In this embodiment, the vacuum waveguide 13 is connected to the plasma generation chamber perpendicular to the direction of the magnetic flux. This embodiment is also equipped with the permanent magnets 34A and 34B, the formation of thin films can be carried out at a high rate and a lower voltage applied to the target. Fig. 24 illustrates the distribution of intensity of magnetic field in the direction of the magnetic fluxes in this embodiment. The distribution of the magnetic fluxes is substantially similar to that (Fig. 15) of the embodiment described above with reference to Fig. 14. In this embodiment, the plasma is not accelerated to the direction of the vacuum waveguide, so that the microwave introduction window 17 is prevented from being dimmed. As a result, even when an electrically conductive material is used as a target 23, it is possible to continue the formation of a thin film for a long period of time in a stable manner. It is preferable that the vacuum waveguide 13 has at least one bend.

In the above-described embodiments, the magnetic coils are used to obtain a mirror field, but it is apparent to those skilled in the art that various permanent magnets and the combinations thereof can be used to produce a mirror field and that the gradient of the mirror field can be made asymmetrical.

Furthermore, it is apparent that suitable electromagnets, yokes and combinations thereof may be used to cause the leakage of the magnetic fluxes to the surface of a cylindrical target.

In the cases of the embodiments described above, the yokes are disposed around the vacuum waveguide in order to absorb the magnetic flux in the vacuum waveguide, but it is apparent that the same effect can be obtained even when the vacuum waveguide is made of a suitable material capable of absorbing the magnetic flux.

So far, the embodiments of the thin film forming apparatus in accordance with the present invention have been described as being equipped with the ion generation apparatus in which a target is sputtered by high density plasma and the sputtered particles are then ionized. One or more yokes, the vacuum waveguide connected to the plasma generation chamber perpendicular to the magnetic fluxes and the permanent magnets or yokes disposed to surround the plasma generation chamber in opposed relationship with the upper and lower ends of the target placed in the plasma generation chamber can be used to improve a first embodiment of an ion source in accordance with the present invention shown in Figs. 8 and 9. Therefore, some embodiments of the ion source of the present invention will be described in detail below.

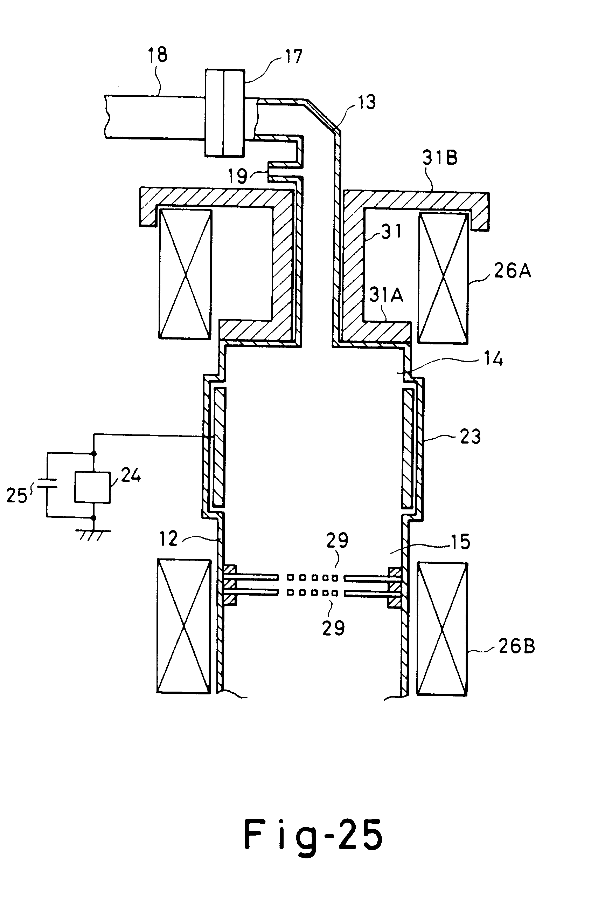

Fig. 25 is a sectional view showing an ion source equipped with a yoke 31 made of, for instance, soft magnetic iron. As in the case of the thin film forming apparatus shown in Fig. 10, the cylindrical surface 31A of the yoke 31, which is opposed to the outer cylindrical wall of the plasma generation chamber 14, is enlarged in area as practically as possible so that a uniform magnetic field distribution can be obtained within the plasma generation chamber 14. In addition, in order to decrease the magnetic resistance of the electromagnet 26A itself, the outer end 31 B of the yoke 31 is so disposed as to surround one end of the electromagnet 26A so as to absorb the magnetic fluxes. Furthermore, the vacuum waveguide 13 is made in the form of an L and the microwave introduction window is disposed at the position which cannot be viewed from the target 23. The remaining construction is substantially similar to that of the ion source shown in Figs. 8 and 9. In Fig. 25, the specimen chamber, the substrate and the exhaust port are not shown for the sake of simplicity.

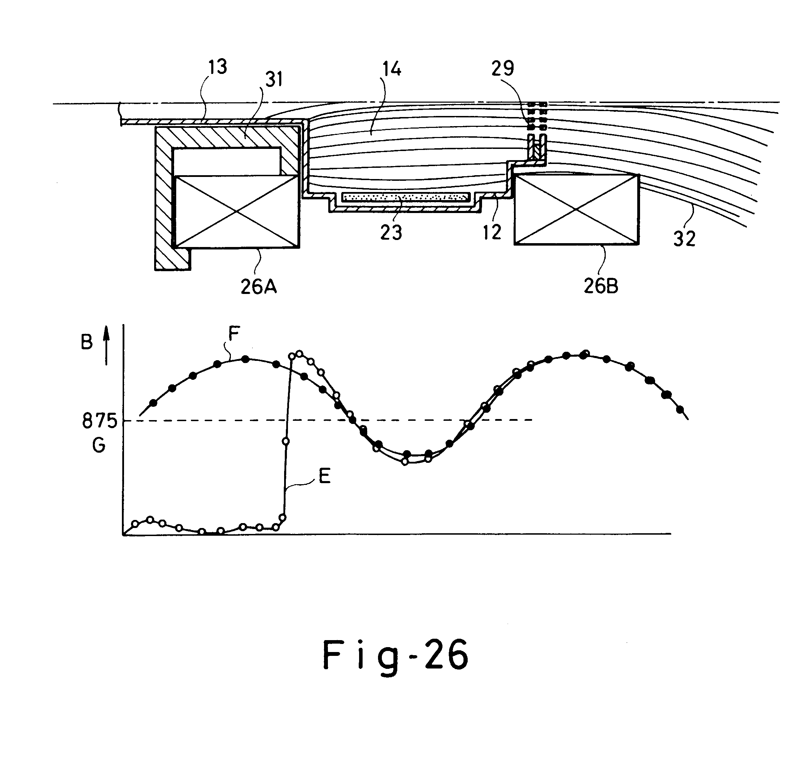

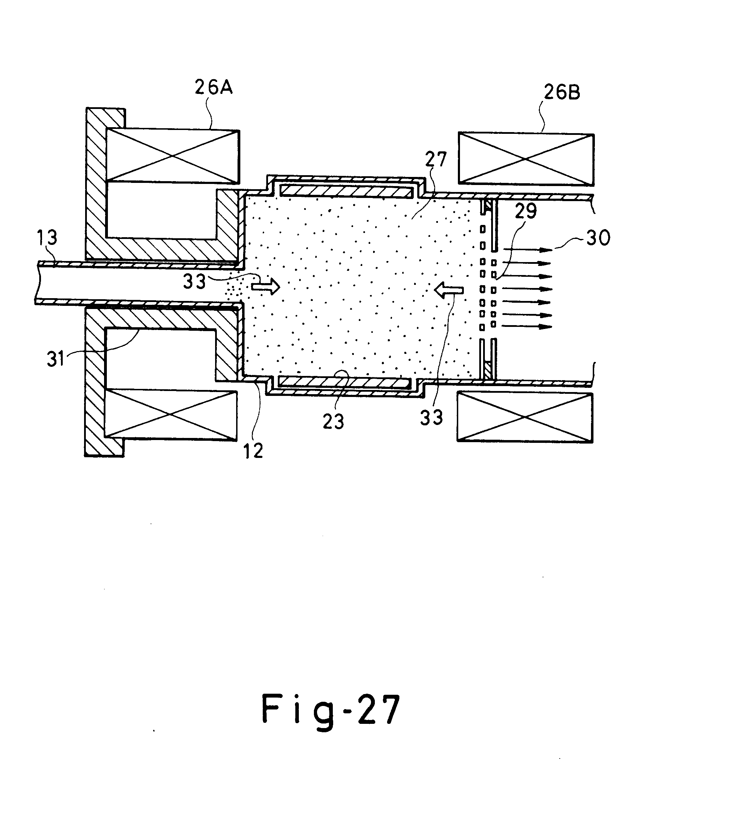

Fig. 26 illustrates the distribution of intensity of magnetic field in the direction of the magnetic flux in the embodiment of the ion source shown in Fig. 25. The curve E indicates the intensity of magnetic field while the curve F indicates the intensity of magnetic field when the yoke 31 is not used. Regardless whether the exraction grid is provided or not, the intensity of the magnetic field abruptly varies between the vacuum waveguide 13 and the plasma generation chamber 14. Therefore, the direction of the acceleration of the plasma is the direction toward the inside of the ion generation chamber 14 as shown in Fig. 27 and the plasma is not accelerated in the direction of the vacuum waveguide 13. As a result, even when the ion beams are extracted for a long period of time, they can be extracted in a stable manner without dimming the microwave introduction window 17.

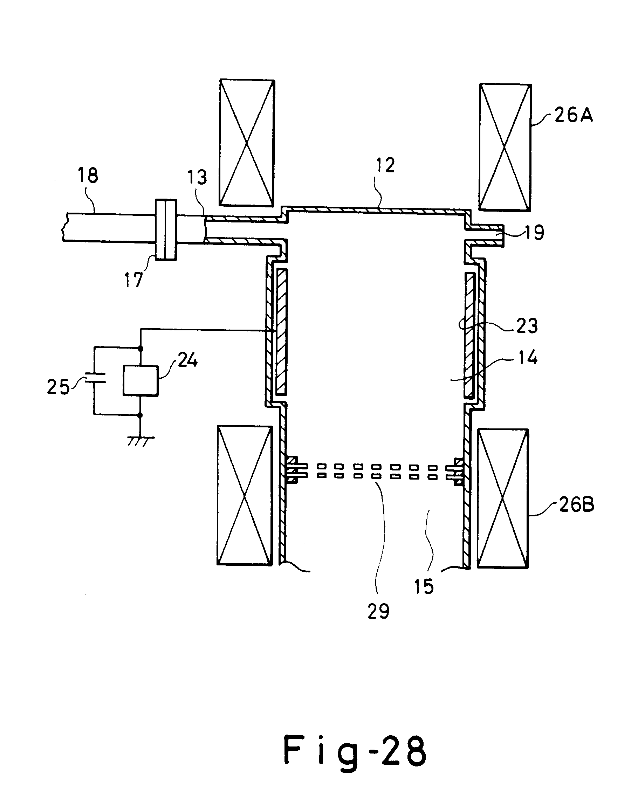

Fig. 28 is a sectional view showing a third embodiment of an ion source in accordance with the present invention. In this embodiment, the vacuum waveguide 13 is connected to the plasma generation chamber 14 in the direction perpendicular to the magnetic flux and the microwave introduction window 17 is disposed at the position which cannot be viewed directly from the target 23.

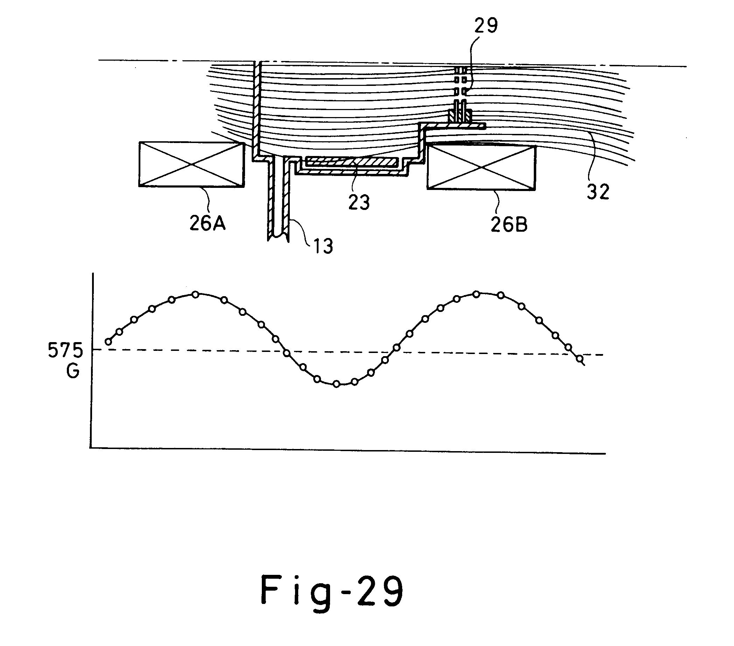

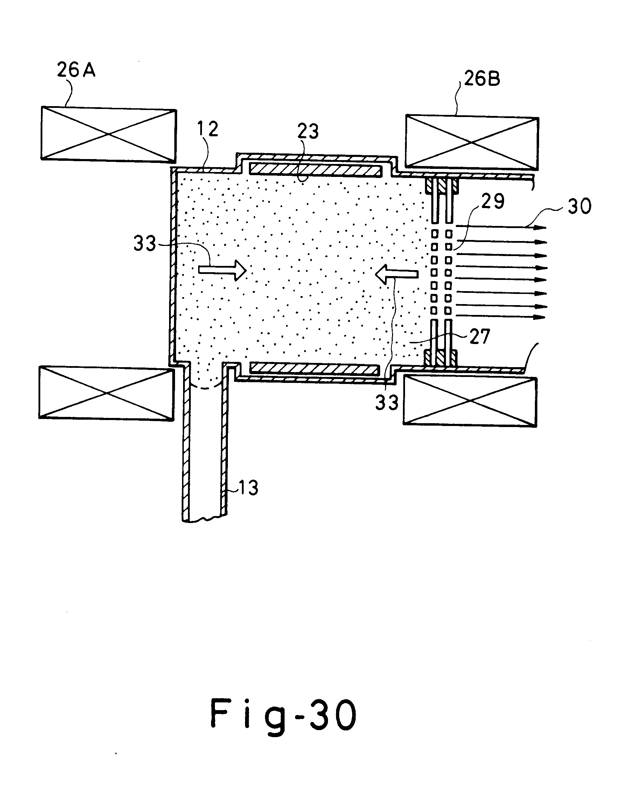

Fig. 29 illustrates the distribution of the intensity of magnetic field in the direction of the magnetic flux in this embodiment of the ion source and Fig. 30 illustrates the mode of plasma generation and the direction of acceleration thereof. The results of the comparison between Fig. 29 and Fig. 15 and between Fig. 30 and Fig. 16 show that the effects attained in the ion source by the connection of the vacuum waveguide 13 with the plasma generation chamber in the direction perpendicular to the magnetic flux are substantially similar to those attained by the thin film forming apparatus described above with reference to Fig. 14. That is, since the plasma is not diverged in the direction perpendicular to the magnetic flux, the microwave introduction window 17 will not be dimmed and the ion beams 30 can be extracted through the grid 29 in a stable manner. It follows therefore that it becomes possible to carry out the thin film formation process in a stable manner for a long period of time even when electrically conductive materials are used as a target material. It is preferable that the vacuum waveguide 13 has one or more bends.

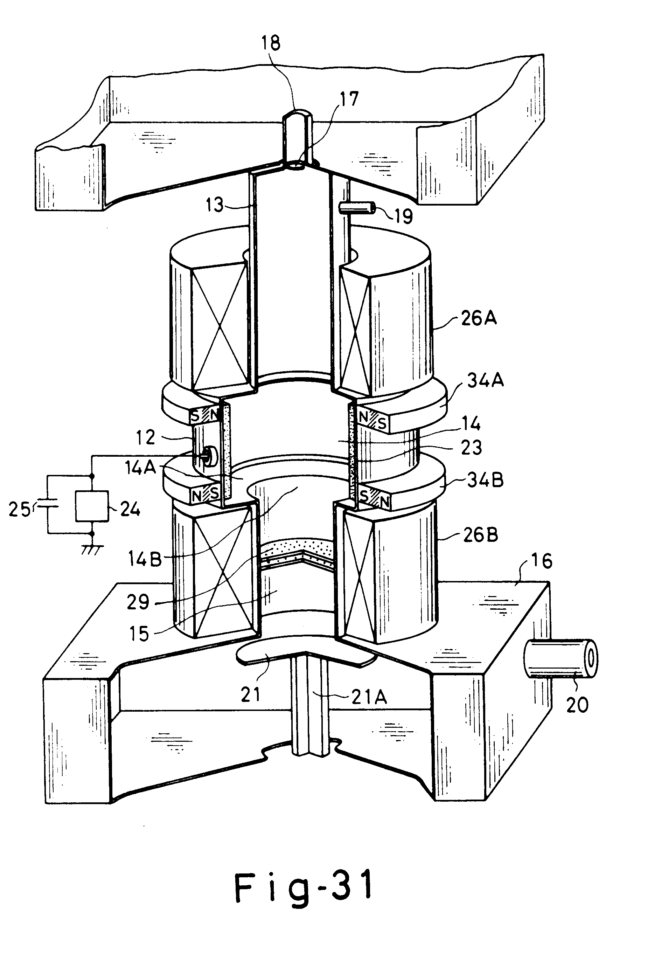

Fig. 31 shows a fourth embodiment of an ion source in accordance with the present invention. This embodiment is substantially similar in construction to the ion source described above with reference to Figs. 8 and 9 except that in order to leak the magnetic flux to the inner surface of the cylindrical target 23, at least one pair of ring-shaped permanent magnets 34A and 34B are disposed in such a manner that the polarity of the magnet 34A is opposite to those of the magnet 34B.

As described above, by applying negative voltage to the target 23, which is faced to the high density plasma confined by the mirror field, the ions in the high density plasma are efficiently attracted to the target causing sputtering. When the ions are attracted and impinge on the surface of the target 23, the secondary electrons are emitted from the surface of the target. These electrons are accelerated away from the target with the high-energy corresponding to the voltage applied to the target. The secondary electrons have higher energy and therefore greatly affect the ionization efficiently of gas.

The secondary electrons, which is accelerated by the electric field at the surface of the target produced by the voltage applied there to, are deflected by the magnetic field J3 formed by the permanent magnets 34A and 34B and are forced to return in the direction of the target, but they are accelerated in the opposite direction by the electric field |E. While repeating the above-described motions the high-energy electrons are drifted in the direction of IE x |B, that is, in the circumference direction of the inner circle of the target while and during these processes they repeatedly collide with the neutral particles. Therefore, the highly efficient ionization of a gas and hence highly efficient sputtering can be carried out at a lower voltage applied to the target. Furthermore, part of almost all neutral particles sputtered from the cylindrical target 23 are ionized in the high electron temperature and high density plasma.

Next, the result of the formation of AI films by this embodiment will be described. First, the plasma generation chamber was evacuated to 7 x 10-⁵ Pa (5 x 10-⁷ Torr) and then Ar gas was introduced into the plasma generation chamber until the gas pressure therein rises to 0,039 Pa (3 x 10-⁴ Torr). Thereafter, under the conditions that the microwave power was 100 - 800 W, the voltage applied to the AI target was -300 V to -1 kV the magnetic flux density on the surface of the target was 4 x 10⁻²Vsm⁻² (400G) and the gradient of the mirror field was maintained at 0,2/7 x 10⁻²Vsm⁻² (2kG/700G), films were formed. In this case, AI⁺ ions having the energy ranging from 20 eV to 100 eV were extracted through the ion extraction grid and a film was efficiently formed at the deposition rate of 3-7nm/min (30 - 70 A/min) over the surface of the substrate disposed below the grid. It is possible to form a film at the same deposition rate and at a lower voltage applied to the target which was about 70% lower than a voltage applied to the target in the apparatus having no permanent magnets 34A and 34B.

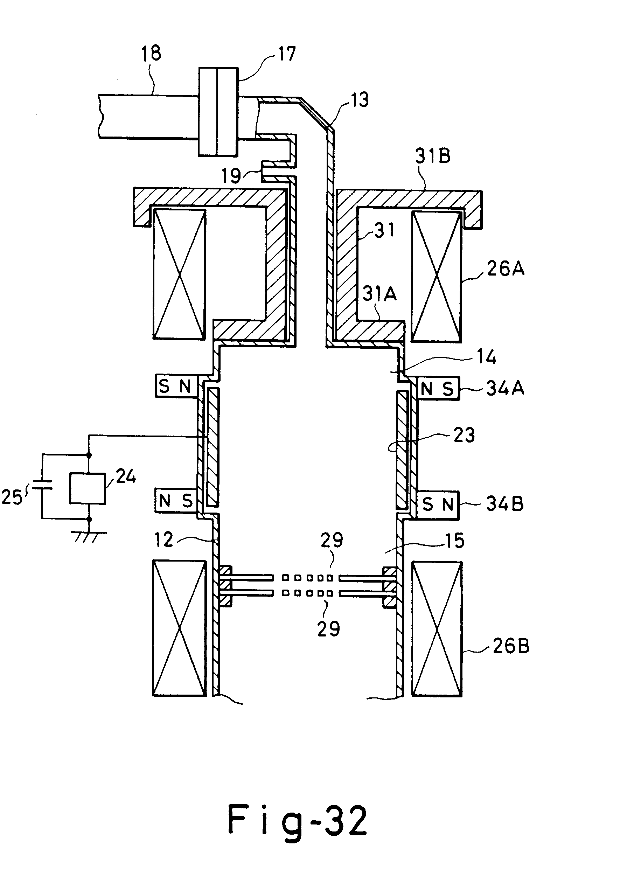

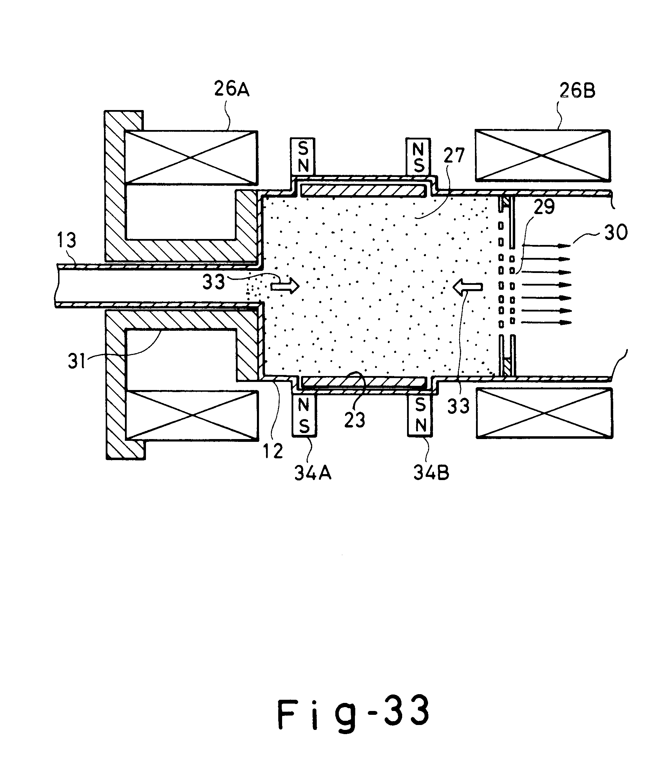

Fig. 32 shows a fifth embodiment of the ion source in accordance with the present invention. This embodiment is substantially similar to the embodiment shown in Fig. 31 as except that this embodiment is equipped with the yoke 31 as shown in Fig. 25. In this embodiment, the permanent magnets 34A and 34B are provided, so that the voltage to be applied to the target can be decreased further. As is apparent from Fig. 33 illustrating the mode of generation of plasma 10 and the direction 33 in which the plasma is accelerated, because of the effect of the yoke 31, the plasma is not accelerated in the direction of the vacuum waveguide 13, accordingly the microwave introduction window 17 is prevented from being dimmed.

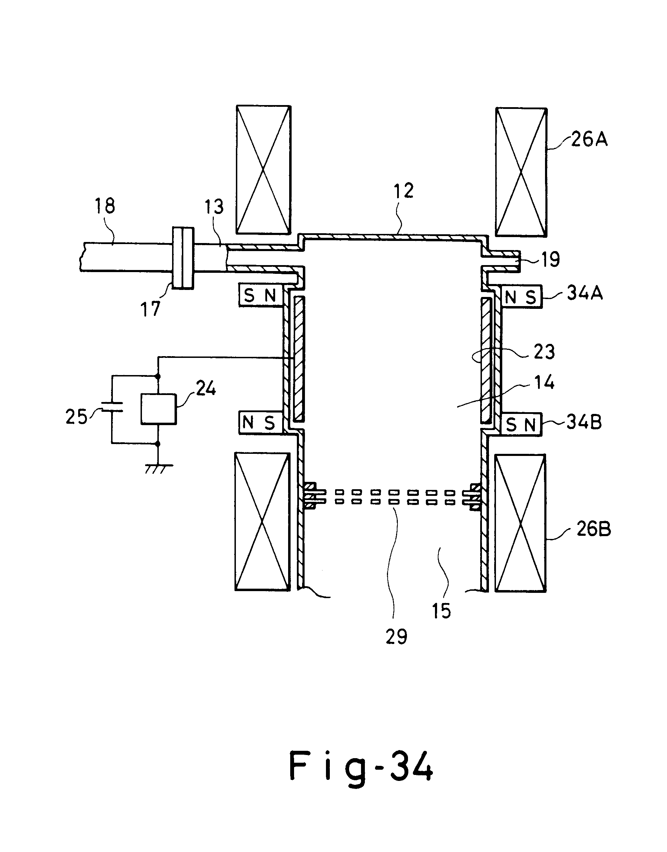

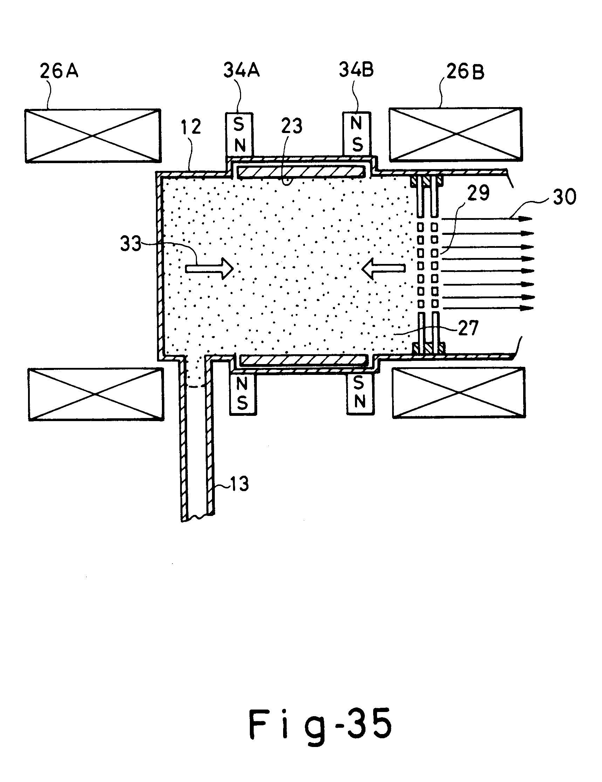

Fig. 34 shows a sixth embodiment of the ion source in accordance with the present invention. This embodiment is substantially similar in construction to the ion source described above with reference to Fig. 31 except the fact that vacuum waveguide 13 is connected to the plasma generation chamber in the direction perpendicular to the magnetic flux. Fig. 35 illustrates the plasma generation mode and the direction in which the plasma is accelerated. It is apparent that the plasma does not transverse the magnetic fluxes and does not diverge in the direction of the vacuum waveguide 13, accordingly the microwave introduction window 17 is not dimmed. This effect is more enhanced when the vacuum waveguide 13 has one or more bends. The ion beams 30 are efficiently extracted through the ion extracting grid 29. Therefore, even when electrically conductive materials are used as the target 23, the ion beams 30 each having a high current can be extracted for a long period of time in a stable manner at a lower voltage applied to a target.

In the embodiments of the ion source in accordance with the present invention, magnetic coils are used to produce a mirror field, but it is apparent that a mirror field can be produced by various permanent magnets and various combinations thereof and the same effects described above can be attained. Furthermore, it is apparent that a mirror field may be asymmetrical.

Furthermore, in order to permit the leakage of the magnetic fluxes to the surface of the cylindrical target, a pair of ring-shaped permanent magnets are used in the above-described embodiments, but it is apparent that the same effects can be attained by using suitable electromagnets, yokes or various combinations thereof.

Moreover, in the above-described embodiments, in order to absorb the magnetic fluxes in the vacuum waveguide, the vacuum waveguide is surrounded with the yoke, but it is also apparent that the same effect can be attained when the vacuum waveguide is made of a suitable material capable of effectively absorb the magnetic fluxes.

As described above, in the ion generation apparatus in accordance with the present invention, plasma is generated by the discharge of the microwave under the condition of the electron cyclotron resonance and trapped or confined by a mirror field and sputtering is carried out by efficiently extracting the ions in the high density plasma. As compared with the prior art sputtering apparatus, highly active plasma can be generated at a low gas pressure and the formation of a film with particles having a high degree of ionization efficiency can be accomplished at a high rate and under a low pressure. Furthermore, the energies of respective particles can be controlled in a wide range from a few electron volts to thousands electron volts and the dispersion of the energies can be reduced to a minimum.

By using the ion generation apparatus in accordance with the present invention, not only the formation of a high quality film having a high degree of purity and less defects can be accomplished at a high rate and at a high degree of efficiency, but also it becomes possible to form at a low temperature a film of an unequilibrium material which has been impossible to form heretofore. Furthermore, according to the present invention, because of the effect attained by a ring-shaped permanent magnet disposed so as to surround the outer side of a cylindrical target, a sputtering process can be carried out at a high efficiency even when the voltage applied to the target is decreased as compared with the apparatus not equipped with a permanent magnet.

When the vacuum waveguide and the magnetic flux absorbing yoke are used, the microwave introduction window is prevented from becoming dim, so that a high quality film having a high degree of purity and having less defects can be continuously formed over the surface of a substrate maintained at a low temperature, at a high degree of growing rate and at a high degree of efficiency for a long period of time in a stable manner regardless of a degree of conductivity and thickness of the film.

Furthermore, when the vacuum waveguide is connected to the plasma generation chamber in the direction perpendicular to the magnetic flux, the microwave introduction window is substantially prevented from becoming dim and regardless of a degree of conductivity and a thickness of a film, the film formation can be carried out continuously for a long period of time.

In the ion sources in accordance with the present invention, a sputtering process is carried out by efficiently extracting ions from high density plasma. The neutral particles produced by the sputtering are ionized in the highly active plasma at a low gas pressure and then extracted at a high degree of efficiency. As compared with the prior art ion sources, the ion extraction at an extremely high electric current density can be realized, and further the deposition of the ions of various high purity metals and compounds and etching by these ions can be carried out. In addition, the present invention has a feature that the energy of the ions can be freely controlled over a wide range from several electron volts to several kilo electron volts. Furthermore, according to the present invention, due to the effects of the permanent magnets disposed to surround a cylindrical target, a high efficiency sputtering can be realized even at a low voltage applied to a target as compared with the ion sources not equipped with such permanent magnets.

Furthermore, in accordance with the present invention, the vacuum waveguide and the magnetic flux absorbing yoke are used so that the microwave introduction window can be prevented from becoming dim. As a result, metal ions can be continuously extracted from a long period of time in a stable manner.

Moreover, according to the present invention, the vacuum waveguide is connected to the plasma generation chamber in the direction perpendicular to the magnetic flux, so that the microwave introduction window can be prevented from becoming dim and regardless of kinds of ions and a degree of conductivity and the thickness thereof, the ion extraction can be realized continuously for a long period of time in a stable manner.

## Claims

1. Apparatus comprising a vacuum chamber (12) including a vacuum waveguide (13) having a microwave introduction window (17) at one end thereof, the microwave introduction window (17) being connected to a microwave waveguide (18), a plasma generation chamber (14) having a diameter and a length sufficient to define a microwave cavity resonator for causing the resonance of the introduced microwave and an end portion of the plasma generation chamber (14) all connected with each other in the order named and further having a gas introduction inlet (19), further comprising
a target (23) to be sputtered disposed in the plasma generation chamber (14) and at least one pair of magnetic field producing means (26A) disposed around the vacuum waveguide (18) and the end portion of the plasma generation chamber (14) so that a mirror field is produced in such a way that the center of the magnetic field exists within the plasma generation chamber (14) characterised in that the target (23) is attached to a portion of the side surface of the plasma generation chamber (14) and a power source is provided for applying a negative voltage to the target.

2. Apparatus as claimed in Claim 1, characterised in that the target (23) is a tube along the inner wall of the plasma generation chamber (14).

3. Apparatus as claimed in Claim 1 or 2, including a specimen chamber having a substrate holder (21 A) disposed therein.

4. Apparatus as claimed in any previous claim, characterised in that at least one pair of second magnetic field producing means (34A,34B) are disposed to surround the plasma generation chamber (14) in opposite magnetic polarity relationship so that the magnetic flux leaks from one end to another end of the inner surface of the target (23).

5. Apparatus as claimed in any previous claim, characterised in that around the vacuum waveguide (13) a magnetic flux absorbing yoke (31) is disposed in such a way that the yoke surrounds one of the magnetic field producing means (26) and is disposed along the vacuum waveguide (13).

6. Apparatus as claimed in any previous claim, including an ion extraction mechanism which is disposed at the end portion of the plasma generation chamber to selectively extract ions which are obtained by sputtering of the target and are ionized within the plasma.

7. Apparatus as claimed in any previous claim, in which the vacuum waveguide (13) has at least one bend and the microwave introduction window is disposed at a position which cannot be directly viewed from the target (23).

## Patentansprüche

1. Gerät, das eine Vakuumkammer (12) mit einem Vakuum-Hohlleiter (13), der an einem Ende ein Mikrowellen-Einlaßfenster (17) hat, das an einen Mikrowellen-Hohlleiter (18) angeschlossen ist, eine Plasma-Erzeugungskammer (14) mit einem Durchmesser und einer Länge, die zum Begrenzen eines Mikrowellen-Hohlraumresonators für das Hervorrufen der Resonanz der eingeleiteten Mikrowelle ausreichend sind, und einen Endabschnitt der Plasmaerzeugungskammer (14) aufweist, die alle miteinander in der genannten Aufeinanderfolge verbunden sind, und das ferner einen Gaseinführungseinlaß (19) hat sowie fernerhin
ein zu bedampfendes Target (23), das in der Plasmaerzeugungskammer angebracht ist, und mindestens ein Paar von Magnetfelderzeugungsvorrichtungen (26A) aufweist, die um den Vakuum-Hohlleiter (18) und den Endabschnitt der Plasmaerzeugungskammer (14) derart angeordnet sind, daß ein Spiegelfeld in der Weise erzeugt wird, daß die Mitte des Magnetfeldes innerhalb der Plasmaerzeugungskammer (14) liegt,
dadurch gekennzeichnet, daß
das Target (23) an einem Teil der Seitenfläche der Plasmaerzeugungskammer (14) angebracht ist und eine Spannungsquelle zum Anlegen einer negativen Spannung an das Target vorgesehen ist.

2. Gerät nach Anspruch 1, dadurch gekennzeichnet, daß das Target (23) ein Rohr entlang der Innenwandung der Plasmaerzeugungskammer (14) ist.

3. Gerät nach Anspruch 1 oder 2, das eine Probenkammer mit einem darin angeordneten Substrathalter (21 A) enthält.

4. Gerät nach irgendeinem vorangehenden Anspruch, dadurch gekennzeichnet, daß um die Plasmaerzeugungskammer (14) herum mindestens ein Paar von zweiten Magnetfelderzeugungsvorrichtungen (34A, 34B) mit entgegengesetzter magnetischer Polarität derart angeordnet ist, daß der Magnetfluß von einem zum anderen Ende der Innenfläche des Target (23) verläuft.

5. Gerät nach irgendeinem vorangehenden Anspruch, dadurch gekennzeichnet, daß um den Vakuum-Hohlleiter (13) herum ein Magnetfluß-Absorptionsjoch (31) derart angeordnet ist, daß das Joch eine der Magnetfeld-Erzeugungsvorrichtungen (26) umgibt und längs des Vakuum-Hohlleiters (13) angeordnet ist.

6. Gerät nach irgendeinem vorangehenden Anspruch, das einen lonenauszugsmechanismus enthält, der an dem Endabschnitt der Plasma- erzeugungskammer angeordnet ist, um selektiv Ionen herauszuziehen, die durch das Bedampfen des Target erhalten werden und die in dem Plasma ionisiert sind.

7. Gerät nach irgendeinem vorangehenden Anspruch, in welchem der Vakuum-Hohlleiter (13) mindestens eine Biegung hat und das Mikrowellen-Einführungsfenster an einer Stelle angeordnet ist, die von dem Target (23) her nicht direkt gesehen werden kann.

## Revendications

1. Appareil comprenant une chambre à vide (12) qui contient un guide d'ondes à vide (13) ayant à l'une de ses extrémités une fenêtre d'introduction de micro-ondes (17), la fenêtre d'introduction de micro-ondes (17) étant reliée à un guide d'ondes fonctionnant en microondes (18), une chambre de génération de plasma (14) ayant un diamètre et une longueur suffisants pour définir un résonateur à cavité micro-onde, pour provoquer la résonance des micro-ondes introduites, et une partie d'extrémité de la chambre de génération de plasma (14), tous reliés les uns aux autres dans l'ordre indiqué, et ayant en outre un orifice d'introduction de gaz (19), comprenant en outre
une cible (23) devant faire l'objet d'une opération de pulvérisation cathodique, disposée dans la chambre de génération de plasma (14), et au moins une paire de moyens de génération de champ magnétique (26a), disposés autour du guide d'ondes à vide (18) et de la partie d'extrémité de la chambre de génération de plasma (14), de façon qu'un champ miroir soit produit d'une manière telle que le centre du champ magnétique se trouve à l'intérieur de la chambre de génération de plasma (14), caractérisé en ce que la cible (23) est fixée sur une partie de la surface latérale de la chambre de génération de plasma (14), et une source d'énergie est incorporée pour appliquer une tension négative à la cible.

2. Appareil selon la revendication 1, caractérisé en ce que la cible (23) est un tube se trouvant le long de la paroi intérieure de la chambre de génération de plasma (14).

3. Appareil selon la revendication 1 ou 2, comprenant une chambre d'échantillon à l'intérieur de laquelle se trouve un porte-substrat (21 A).

4. Appareil selon l'une quelconque des revendications précédentes, caractérisé en ce qu'au moins une paire de seconds moyens de génération de champ magnétique (34A, 34B) est disposée de façon à entourer la chambre de génération de plasma (14) avec une relation de polarité magnétique opposée, de façon à produire une fuite de flux magnétique d'une extrémité vers l'autre extrémité de la surface intérieure de la cible (23).

5. Appareil selon l'une quelconque des revendications précédentes, caractérisé en ce qu'une culasse absorbant le flux magnétique (31) est disposée autour du guide d'ondes à vide (13), d'une manière telle que la culasse entoure l'un des moyens de génération de champ magnétique (26) et soit disposée le long du guide d'ondes à vide (13).

Appareil selon l'une quelconque des revendication précédentes, comprenant un mécanisme d'extraction d'ions qui est disposé dans la partie d'extrémité de la chambre de génération de plasma, pour extraire sélectivement des ions qui sont obtenus par pulvérisation cathodique de la cible et qui sont Ionisés à l,intérieur du plasma.

Appareil selon l'une quelconque des revendications précédentes, dans lequel le guide d'ondes à vide (13) comporte au moins un coude et la fenêtre d'introduction de micro- ondes est disposée dans une position dans laquelle la cible (23) ne peut pas la voir directement.
